# EUROPÄISCHE PATENTSCHRIFT

(11) **EP 0 393 436 B1**
(45) Veröffentlichungstag und Bekanntmachung des Hinweises auf die Patenterteilung: **12.07.1995**
(21) Anmeldenummer: 90106590.4
(22) Anmeldetag: 06.04.1990
(51) Int. Cl.: G11C 5/02, G11C 11/41, G11C 11/419

(54) **Statischer Speicher mit Pipelineregistern**
Static memory with pipe-line registers
Mémoire statique avec des registres "pipe-line"

(30) Priorität: 21.04.1989 DE 3913208
(43) Veröffentlichungstag der Anmeldung: 24.10.1990
(73) Patentinhaber: SIEMENS AKTIENGESELLSCHAFT, 80333 München (DE)
(72) Erfinder: Schmitt-Landsiedel, Doris, Dr. rer. nat., D-8012 Ottobrunn (DE); Hoppe, Bernhard, Dr. rer. nat., D-6000 Frankfurt 1 (DE); Neuendorf, Gerd, Dipl.-Ing., D-8034 Germering (DE); Wurm, Maria, D-8012 Ottobrunn (DE)

(56) Entgegenhaltungen:
- EP-A- 0 199 134
- EP-A- 0 233 968
- EP-A- 0 249 413
- EP-A- 0 303 811
- WO-A-88/09995
- US-A- 4 712 197
- MEAD CARVER A ET AL 'Introduction to VLSI Systems' Oktober 1980 , ADDISON-WESLEY , READING US
- IEEE JOURNAL OF SOLID-STATE CIRCUITS. Bd. 23, Nr. 5, Oktober 1988, NEW YORK US Seiten 1060 - 1066; KOHNO ET AL: 'A 14-ns 1-Mbit CMOS SRAM with Variable Bit Organization'
- IBM TECHNICAL DISCLOSURE BULLETIN. Bd. 31, Nr. 1, Juni 1988, NEW YORK US Seite 291; 'Combined single/dual-port array approach with 6-device cell'
- ELECTRONICS AND COMMUNICATIONS IN JAPAN. Bd. 63, Nr. 9, September 1980, NEW YORK US Seiten 81 - 90; FUKUDA ET AL: '256-bit Elastic Store CMOS LSI'
- WESTE NEIL H E ET AL 'Principles of CMOS VLSI Design - A Systems Perspective' Oktober 1985 , ADDISON-WESLEY , READING US
- MAVOR ET AL 'Introduction to MOS LSI Design' 1983 , ADDISON-WESLEY , LONDON UK
- PROCEEDINGS IEEE COMP EURO 89 - VLSI AND COMPUTER PERIPHERALS 8. Mai 1989, WASHINGTON US, SCHMITT-LANDSIEDEL ET AL: "Hierarchical Architecture for Fast CMOS SRAMs"

## Beschreibung

Die Erfindung betrifft einen aus Speicherzellen hierarchisch aufgebauten Speicher nach dem Oberbegriff des Patentanspruches 1.

Ein derartiger hierarchisch aufgebauter Speicher ist aus der Veröffentlichung von C. Mead, L. Conway "Introduction to VLSI-Systems", Second Edition, Addison-Wesley, 1980, Kap. 8.5.2 für dynamische Speicherzellen bekannt, wobei jedoch keine detaillierten Angaben zur Ausführung der Zeilen- und Spaltenleitungen und insbesondere keine Angaben bezüglich vorzusehender Pipelinestufen zu entnehmen sind.

Statische Speicher (SRAMS) in CMOS-Technologie arbeiten entweder asynchron, d.h. ein Schreib- oder Lesevorgang wird von einem Wechsel der Eingangsdaten ausgelöst, oder sie operieren synchron zu einem Takt, wobei am Eingang und am Ausgang Register angebracht sind. Als Eingangsdaten können hier Adresssignale, Dateneingangssignale, Chip Enable Signale oder andere Steuersignale angesehen werden. Die Steuerung mit einem Takt kann vorteilhaft sein, weil die Eingangsdaten zu einem definierten Zeitpunkt bezogen auf den Systemtakt übernommen werden und die Ausgangsdaten zu einen definierten Zeitpunkt zur Verfügung stehen. Dadurch wird der Datentransfer zwischen den Bausteinen eines Systems mit hoher Taktfrequenz erleichtert. Aus diesen Überlegungen heraus wurden die sog. synchronen statischen Speicher entwickelt, die auch als "REGISTERED SRAMS" oder "Pipelined SRAMS" bezeichnet werden. Solche synchronen SRAMS findet man in der Veröffentlichung GaAs IC Data book and designer's guide "256 x 4 bit registered self-timed static RAM 2.5 ns cycle time", Giga Bit Logic Inc. May 1988, Seite 2-2ff sowie in der Veröffentlichung CMOS data book "advanced information: self timed pipelined static RAMs", Cypress Semiconductors, 15.01.1988, Seite 2-83. Die hier wiedergegebenen statischen Speicher enthalten jedoch nur Pipelineregister an ihren Eingängen und Ausgängen .

Neben der genannten Synchronisierung ist es das eigentliche Ziel der Pipelinearchitektur, eine möglichst hohe Taktfrequenz zum Betrieb einer Schaltung zu erzielen. Dies wird erreicht durch Aufteilen des Datenpfades in mehrere Abschnitte, die taktgesteuert zeitlich parallel für mehrere Datensätze betrieben werden. Die Daten werden nach Durchlaufen einer Pipelinestufe jeweils in Registern zwischengespeichert. Die kürzestmögliche Taktperiode wird dabei durch die Pipelinestufe bzw. die Pipelinestufen mit der längsten Durchlaufzeit bestimmt. Die gesamte Laufzeit der Daten durch die Schaltung ist länger als bei einer Schaltung ohne Pipelinestruktur, aber die Datenrate kann - abhängig von der Zahl der Pipelinestufen und der zusätzlichen Laufzeit durch die Register - wesentlich erhöht werden. Dieser Vorteil wird erkauft durch einen zusätzlichen Flächenaufwand für die Pipelineregister sowie die Erzeugung und Verteilung der Taktsignale.

Eine Unterteilung des Lese- oder Schreibvorgangs in weitere Pipelinestufen ist mit konventioneller Speicherarchitektur ohne hierarchische Stufen nicht sinnvoll. Die Eingangssignale verzweigen - evtl. nach einer Vordecoderstufe, die jedoch nur einen geringen Teil der Zugriffszeit beansprucht - zu einer Vielzahl von Wortleitungen. Wegen der großen Anzahl von Wortleitungen, der erforderlichen Treiberstärke für das Wortleitungssignal und den Geometrievorgaben durch das Zellraster ist es nicht sinnvoll, an dieser Stelle weitere Pipelineregister in den Adresspfad einzufügen. Die Ausgangsdaten werden aus einer Vielzahl von Datenleitungen ausgewählt und einem oder mehreren Leseverstärkern zugeführt. Eine Zwischenspeicherung ist hier erst nach dem Leseverstärker sinnvoll.

Der Erfindung liegt die Aufgabe zugrunde, einen hierarchisch aufgebauten Speicher anzugeben, der in den mittleren und höheren Hierarchieebenen mehrere Pipelinestufen enthält.

Diese Aufgaben werden erfindungsgemäß durch die im kennzeichnenden Teil des Patentanspruchs 1 angegebenen Merkmale gelöst.

Ein solcher hierarchischer Speicher mit Pipelinestruktur kann vorteilhaft eingesetzt werden, wenn eine hohe Datenrate besonders wichtig ist, während eine Wartezeit von mehreren Taktperioden zwischen dem Anlegen einer Adresse und dem Auslesen der zugehörigen Daten bzw. dem Beschreiben der Speicherzellen nicht stört. Daher sind diese Speicher besonders bei schnellen Testern oder in der digitalen Signalverarbeitung optimal verwendbar.

Die Patentansprüche 2-13 sind auf eine bevorzugte Ausgestaltung des Speichers gerichtet, die dort näher erläutert wird.

Die Erfindung wird nachfolgend anhand von Zeichnungen näher beschrieben, es zeigen dabei:
- Figur 1: das Blockschaltbild eines erfindungsgemäßen Speichers mit vier Hierarchieebenen und eingefügten Pipelineregistern,
- Figur 2: das Blockschaltbild für einen erfindungsgemäßen 16-K Speicher mit fünf Pipelinestufen,
- Figur 3: Zeitdiagramm für die Takterzeugung und das Rücksetzen der Z2-Signale,
- Figur 4: Zeitdiagramm für den Signalverlauf durch die aufeinanderfolgenden Pipelinestufen,
- Figur 5: Schaltbild der zentralen Taktversorgung,
- Figur 6: Schaltbild des Ein- und Ausgangstaktgenerators,
- Figur 7: Schaltbild für ein statisches Register mit Resetschaltung.

Durch den hierarchischen Aufbau ist es - anders als bei konventionellen statischen Speichern - möglich, in den mittleren und oberen Hierarchieebenen mehrere Pipelinestufen einzufügen, da hier die Zahl der zu speichernden Signale nicht so groß ist und nicht adressierte Unterblöcke vom Pipelinebetrieb abgeschaltet werden können. Die Laufzeit durch die unteren Hierarchieebenen ist deutlich kürzer als die gesamte Zugriffszeit. Daher ist auch die erzielbare minimale Taktperiode wesentlich kürzer als bei herkömmlichen synchronen statischen Speichern.

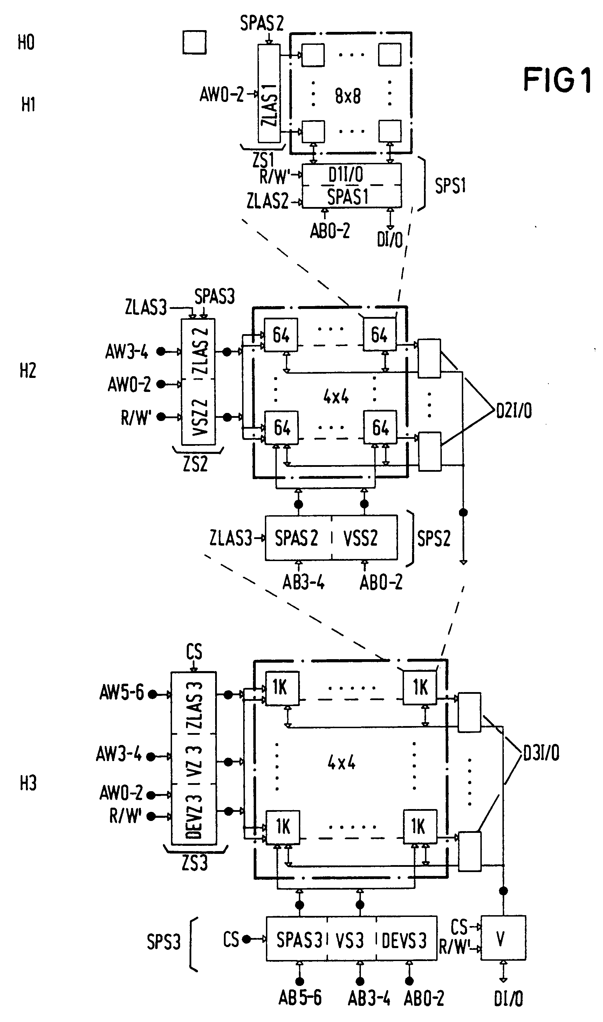

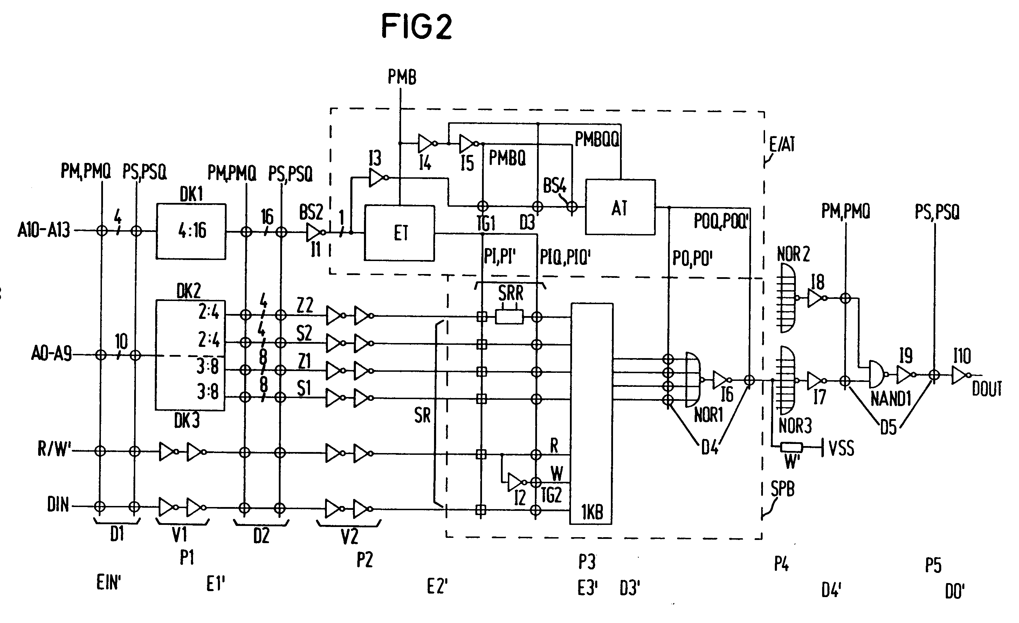

Als Beispiel sei hier in Figur 1 das Blockschaltbild eines hierarchischen 16K SRAMS mit eingefügten Registern in der zweiten und dritten Hierarchieebene gezeigt. Der prinzipielle hierarchische Aufbau entspricht hierbei der Figur 2 in der Patentanmeldung 88 E 1877DE "Statischer Speicher". Nach Simulationen für eine 1 um CMOS-Technologie ist die Zugriffszeit eines hierarchischen 16K SRAMS mit on-chip Ein- und Ausgangsschaltungen etwa 11 Nanosekunden. Beim vorliegenden Stand der Technik, benötigt die zeitkritische Stufe ohne Berücksichtigung der Ein- Ausgangsschaltungen etwa 9 Nanosekunden Durchlaufzeit zwischen dem Ein- und Ausgang. Die Durchlaufzeit zwischen Ein- und Ausgang der zweiten Hierarchieebene beträgt ca. 4 Nanosekunden. Damit kann die Taktperiode bei Einführung der gezeigten Pipelinestufe auf etwa die Hälfte gegenüber getakteten mit hierarchischer Architektur aufgebauten Speichern reduziert werden, bzw. im Vergleich mit einer konventionellen Architektur ohne hierarchischen Aufbau kann die Taktperiode um etwa ein Drittel verringert werden.

Figur 1 zeigt das Blockschaltbild eines beispielhaften statischen 16K Speichers mit hierarchischer Pipeline Architektur. In diesem Beispiel wird der Speicher in vier Hierarchieebenen aufgebaut. Die erste Hierarchieebene H0 wird durch eine einzelne Speicherzelle gebildet, während auf der zweiten Hierarchieebene H1 8x8 Speicherzellen zu einer Speichergruppe zusammengefaßt sind. In der dritten Hierarchieebene H2 sind 4x4 Speichergruppen zusammengefaßt, wobei jede Speichergruppe 64 Speicherzellen enthält. In der vierten Hierarchieebene H3 schließlich sind 4x4 Blöcke angeordnet, wobei jeder einzelne dieser Blöcke eine Speicherkapazität von 1K Bit besitzt und entsprechend der 4x4 Speichergruppen auf der dritten Hierarchieebene H2 aufgebaut ist. Um eine schnelle Zugriffszeit bei guter Raumausnutzung zu gewährleisten wurde die Aufteilung des Speichers in vier Hierarchieebenen gewählt. Eine andere Aufteilung ist ebenfalls möglich und richtet sich nach den Einsatzerfordernissen.

Für einen hierarchisch organisierten statischen Speicher muß ein neues Dekodierschema entwickelt werden. Um eine möglichst geringe Leistungsaufnahme des statischen Speichers zu erzielen und um die Verzögerungszeit zu verringern, die sich aufgrund eines hohen "Fan-out" der Multiplexer und Decodierschaltungen auf der jeweiligen Hierarchieebene ergeben, ist es nicht vorteilhaft die Dateneingänge und die niedrigen Adressleitungen an allen Speichergruppen auf jeder Hierarchieebene zu aktivieren. Stattdessen ist es vorteilhaft, Signale auf diesen Leitungen auf höheren Hierarchieebenen vorzuselektieren. Dies wird mit Hilfe von Blockselektsignalen ermöglicht, die von den höherwertigen Adressbits erzeugt werden. Hierdurch werden die vorselektierten Adress- und Datensignale nur zu den vorausgewählten Unterblöcken weitergeleitet. Würden jedoch alle Signale auf den Daten- und niedrigen Adressleitungen auf jeder Hierarchieebene selektiert, so würde dies aufgrund der benötigten Gatteranordnungen in dem Decodierpfad eine zu hohe Verzögerungszeit verursachen. Um dies zu vermeiden werden Teile der Decodierung in parallelarbeitende Blöcke aufgeteilt.

Demzufolge sind auf der zweiten Hierarchieebene H1 allen Spalten von 8x8 Speicherzellen eine Datenein- und Datenausgangsschaltung D1I/O zugeordnet, während auf der dritten Hierarchieebene H2 je eine Datenein- und Datenausgangsschaltung D2I/O pro Zeile der 64 Speicherzeilenelemente vorhanden sind. Ebenso ist auf der vierten Hierarchieebene H3 einer Zeile von 1K Speicherblöcken jeweils eine Datenein- und Datenausgangsschaltung D3I/O zugeordnet. Die Datenleitungen der vierten Hierarchieebene H3 werden auf einen Verstärker und Zwischenspeicher V-geschaltet, der ein gezieltes Datenein- und Auslesen für den statischen Speicher ermöglicht. Hierfür wird der Verstärker und Zwischenspeicher mit einem Chipselektsignal CS und einem Schreiblesesignal R/W′ angesteuert. Wie aus der Figur 1 ersichtlich ist in der zweiten ,dritten und vierten Hierarchiestufe H1, H2 und H3 je eine Zeilen- und Spaltenschaltung ZS1, ZS2, ZS3, bzw. SPS1, SPS2, SPS3 vorhanden, die jedoch auf jeder Hierarchiestufe unterschiedlich ausgebildet sind. Auf der vierten Hierarchiestufe H3 enthält eine Spaltenschaltung SPS3 eine Spaltenauswahlschaltung SPAS3 für die höchstwertigen Adressbits AB5 und AB6, einen Verstärker und Zwischenspeicher VS3 für die Adressbits der Bitleitungen AB3 bis AB4 und eine Decodier- und Vorselektionseinrichtung DEVS3 für die niedrigstwertigen Adressbits der Bitleitungen AB0 bis AB2. Ebenso enthält die Zeilenschaltung ZS3 auf dieser Hierarchieebene eine dreifache Aufteilung bestehend aus einer Decodier- und Vorselektionseinrichtung DEVZ3 für die niedrigstwertigen Adressbits der Bitleitungen AW0 bis AW2 und des angelegten Schreib- Lesesignals R/W′, einen Verstärker und Zwischenspeicher VZ3 für die Adressbits der Wortleitungen AW3 bis AW4 und eine Zeilenauswahlschaltung ZLAS3 für die höchstwertigen Adressbits der Wortleitungen AW5 und AW6. Sowohl die Zeilenschaltung ZS3 als auch die Spaltenschaltung SPS3 auf dieser Hierarchieebene werden jeweils mit Chipselektsignalen CS angesteuert. Die Decodiereinrichtung in der Zeilen- und Spaltenschaltung DEVZ3, DEVS3 auf der Hierarchieebene H3 decodiert bereits die niedrigstwertigen Adressbits AB0 bis AB2 bzw. AW0 bis AW2 die erst auf der zweiten Hierarchieebene H1 benötigt werden. Um die niedrigstwertigen Adressbits nicht auf alle der 1K Blöcke zu schalten, werden diese mit Hilfe der höchstwertigsten Adressbits AW5 und AW6 bzw. AB5 und AB6 vorselektiert und nur einer Zeile bzw. einer Spalte von 1K Blöcken aufgeschaltet. Dies wird ermöglicht durch intern generierte Blockselektsignale in der Zeilen- und Spaltenschaltung ZS3, SPS3. Auf der vierten Hierachieebene H3 sind an den Eingängen und Ausgängen der Zeilenschaltung ZS3 als auch der Spaltenschaltung SPS3 jeweils Register angeordnet, ebenso wie zwischen dem Verstärker und Zwischenspeicher V und den Datenein und -ausgangsschaltungen D3I/O. Hierdurch wird der statische Speicher der vierten Hierarchieebene bezüglich der Adressleitungen und der Datenein und -ausgangsleitungen jeweils in zwei Stufen weiter unterteilt. Auf der dritten Hierarchieebene enthält die Spaltenschaltung SPS2 eine Vorselektionseinrichtung VSS2, der die decodierten niedrigstwertigsten Adressbits der Bitleitungen AB0 bis AB2 zugeführt sind und eine Spaltenauswahlschaltung SPAS2 an die die Adressbits der Bitleitungen AB3 und AB4 angeschlossen sind.

Weiterhin benötigt werden für die Speicherschaltung SPS2 das Zeilenauswahlsignal aus der Zeilenauswahlschaltung ZLAS3 der Hierarchieebene H3. Auch die Zeilenschaltung ZS2 der Hierarchieebene H2 enthält eine Zweifachaufteilung bestehend aus einer Vorselektionseinrichtung VSZ2, der die decodierten niedrigstwertigsten Adressbits der Wortleitung AW0 bis AW2 und das vorselektierte Schreib- Lesesignal R/W′ zugeführt werden und an der Zeilenauswahlschaltung ZLAS2, an die die Adressen der Wortleitung AW3 und AW4 anzuschließen sind. Angesteuert wird die Zeilenschaltung ZS2 auf der dritten Hierarchieebene H2 aus dem Spaltenauswahlsignal der Spaltenauswahlschaltung SPAS3 und dem Zeilenauswahlsignal der Zeilenauswahlschaltung ZLAS3, jeweils aus der vierten Hierarchieebene H3. Auch auf der dritten Hierarchieebene H2 werden die niedrigstwertigsten decodierten Adressbits AB0 bis AB2 bzw. AW0 bis AW2 vorselektiert und nur an eine Spalte bzw. Zeile von Speichergruppen aus 64 Speicherzellen aufgeschaltet. Dies wird hier mit Hilfe von intern gebildeten Blockselektsignalen erreicht, die aus den Adressen der Bitleitungen AB3 und AB4 bzw. AW3 und AW4 generiert werden. In der dritten Hierarchieebene sind die Pipelineregister an gleicher Stelle angeordnet wie in der vierten Hierarchieebene. Sie befinden sich zwischen den Ein- und Ausgängen der Spaltenschaltung SPS2 und den Ein- und Ausgängen der Zeilenschaltung ZS2. Weiterhin sind Register vor den Datenein und-ausgangsschaltungen D2I/O angeordnet. Bei einer gemeinsamen Betrachtung aller Hierarchieebenen ergibt sich somit eine Aufteilung von fünf Pipelinestufen zwischen Adress- und Dateneingangsleitungen und den Datenausgangsleitungen. In der zweiten Hierarchieebene H1 schließlich ist in der Spaltenschaltung SPS1 eine Datenein- und ausgangsschaltung D1I/O sowie eine Spaltenauswahlschaltung SPAS enthalten. Die Datenein- und Ausgangsschaltung D1I/O steuert den bidirektionalen Datenverkehr zwischen den einzelnen Speicherzellen der Speichergruppe. Der Spaltenschaltung SPS1 sind daher die decodierten niedrigstwertigsten Adressbits der Bitleitung AB0 bis AB2 und die Datenein-und Ausgangsleitungen DI/O aufgeschaltet. Zur Ansteuerung dienen hierbei ein vorselektiertes Schreib/Lesesignal R/W′ für die Datenein-ausgangsschaltung D1I/O und ein Zeilenauswahlsignal ZLAS2 welches in der Zeilenauswahlschaltung ZLAS2 innerhalb der dritten Hierarchieebene H2 gebildet wird. Die Zeilenauswahlschaltung ZS1 der Speichergruppen in der Hierarchieebene H1 enthält lediglich eine Zeilenauswahlschaltung ZLAS1, der die decodierten niedrigstwertigsten Adressbits der Wortleitung AW0 bis AW2 zugeführt werden und die durch ein Spaltenauswahlsignal gesteuert wird. Hierbei wird das Spaltenauswahlsignal wiederum aus der Spaltenauswahlschaltung SPAS2 der nächsthöheren Hierarchieebene H2 entnommen.

Im folgenden wird nun ein Blockschaltbild für die fünf Pipelinestufen eines hierarchischen 16K statischen Speichers angegeben. Besonders vorteilhaft läßt sich die Realisierung mit Hilfe von neuartigen Speicherzellen durchführen, die in der Patentanmeldung 88 E 1876 DE "Statische Speicherzelle" in verschiedenen Varianten beschrieben wurden. Hier ist besonders der Wegfall einer Schreiberholzeit von Bedeutung. Bei konventionellen statischen Speichern ist nach dem Schreiben eine Schreiberholzeit zum Vorladen der Bitleitungen erfoderlich. Um diese Vorgänge zu steuern, muß ein extrem kurzer Schreibpuls von außen angelegt oder intern erzeugt werden. Der kürzestmögliche Schreibzyklus dauert im allgemeinen mindestens solange wie der minimale Lesezyklus. Dies bedeutet aber auch, daß man in einer Pipelinearchitektur beim Einschreiben nicht die gleiche hohe Taktfrequenz anwenden kann wie beim Auslesen, da nach jedem Schreiben die Schreiberholzeit abgewertet werden muß, bevor der nächste Zugriff erfolgen kann. Es ist jedoch wünschenswert, daß der statische Speicher beim Lesen und Schreiben mit der gleichen Taktfrequenz betrieben werden kann. Dies ist mit Hilfe der Speicherzellen aus der Patentanmeldung 88 E 1876 DE möglich. Wegen der kurzen Wort-und Datenleitungen können Speicherzellen in dieser genannten Patentanmeldung hier wie ein Register in einer logischen Schaltung betrachtet werden. Da statt der üblichen Differenzsignale auf einem Datenleitungspaar ein Datensignal mit dem vollen CMOS-Pegel erzielt wird, kann als Ausleseschaltung ein Inverter verwendet werden, der viel platzsparender ist als ein sonst üblicher Differenzverstärker. Durch den Wegfall von flächenintensiven, mit hohen Entwurfsaufwand verbundenen analogen Schaltungsteilen erhält man beim Einsatz von Speicherzellen eine erhöhte Störsicherheit bei Technologievariationen, eine Verkürzung der Zugriffszeit bei Verwendung der hierarchischen Architektur sowie keinerlei Timing Probleme, z.B. bei der Schreibpulserzeugung und beim Vorladen der Leitungen.

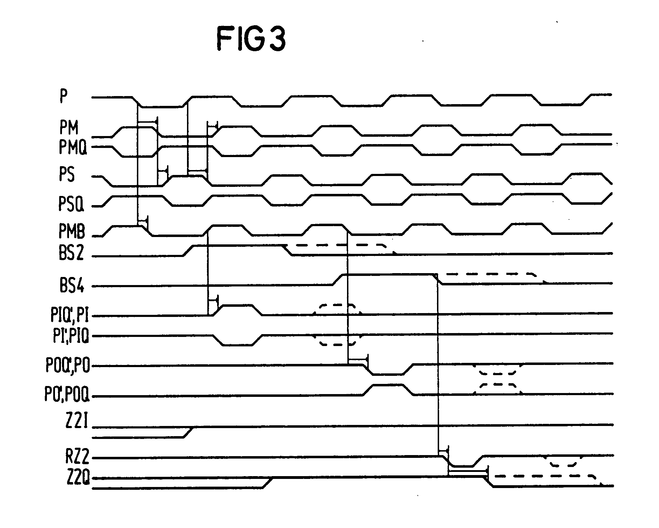

Ein generelles Problem von Pipeline-Schaltungen besteht darin, daß eine Vielzahl von Registern bei jedem Taktzyklus geschaltet wird. Daraus resultiert ein hoher Leistungsverbrauch, und es sind aufwendige und flächenintensive Schaltungen erforderlich, um die verschiedenen Taktphasen in hinreichender Treiberstärke zu generieren. In einer großen Schaltung, bei der Takte über große Distanzen hinweg verdrahtet werden müssen, wird hierbei im allgemeinen aus Gründen der Störsicherheit ein Pseudozweiphasensystem mit vier Taktsignalen PM, PMQ, PS und PSQ zur Anwendung kommen, wie in den oberen vier Zeilen der Figur 3 skizziert. Pseudozweiphasentaktsysteme sind aus der Veröffentlichung von N. Weste, K. Eshragian: "Principles of CMOS VLSI-Design", Addison Wesley, Reading, MA, 1985, Kapitel 5.4, bekannt.

In einem hierarchischen statischen Speicher wird aber bei jedem Zugriff nur ein kleiner Teil der Schaltung wirklich benötigt, nämlich die Schaltungsteile der obersten Hierarchieebene, sowie die adressierten Blöcke der unteren und mittleren Hierarchieebenen. Deshalb wird für den erfindungsgemäßen Speicher vorgeschlagen, ein System von Haupttakten nur für die oberste Hierarchieebene zu generieren und für die Register auf den mittleren und unteren Hierarchieebenen jeweils nur in dem gerade adressierten Block Takte zu erzeugen. Dies kann durch eine logische Verknüpfung eines zu den Haupttakten synchronen, aber möglicherweise zeitlich vorversetzten Taktsignals mit Blockauswahlsignalen erreicht werden.

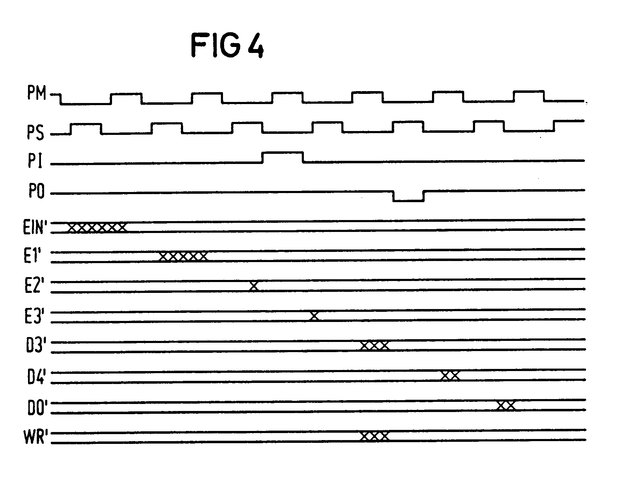

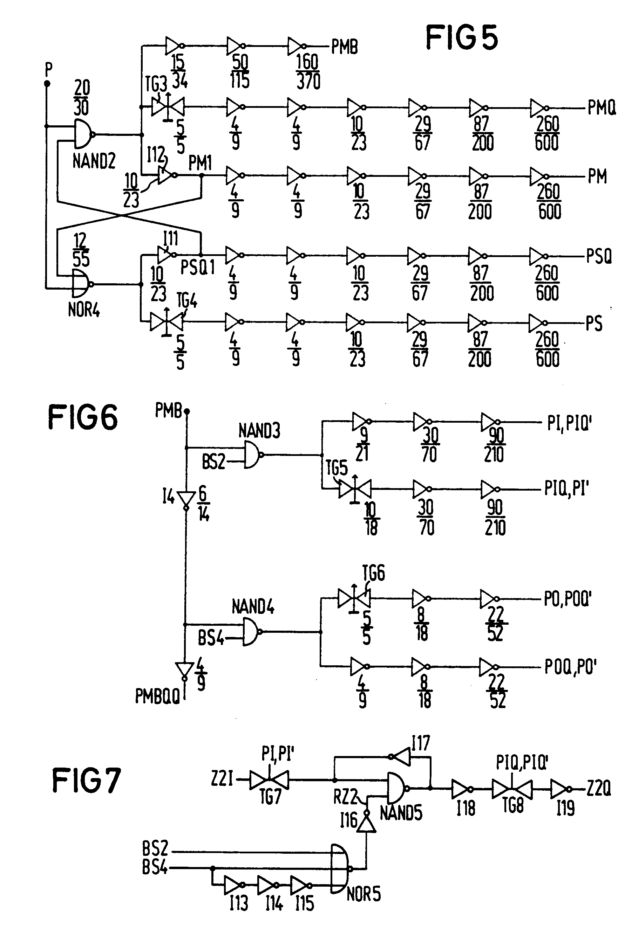

Figur 2 zeigt ein nach dem obengenannten Prinzip beispielshaften 16 K-statischen Speicher mit Pipelinestruktur. Figur 3 und 4 enthalten die Zeitdiagramme für die Erzeugung der Takte und den Signalverlauf durch die aufeinanderfolgenden Pipelinestufen. Ein Vorschlag für die Ausführung der Schaltungen zur Takterzeugung ist in der Figur 5 und Figur 6 angegeben.

Zur Verdeutlichung wird der Signalverlauf für einen Lesevorgang anhand des Blockschaltbildes Figur 2 beschrieben. Das dargestellte hierarchische 16 K SRAM ist aufgeteilt in 16-1K-Blöcke, die aus je 16-64 Bit-Blöcken bestehen. Alle Eingangssignale DIN, R/W′, A0 bis A9, und A10 bis A13 werden zunächst in einer Gruppe von dynamischen Eingangsregistern D1 synchron eingelesen. Die Taktung erfolgt mit Hilfe der Taktsignale PM/PMQ und PS/PSQ aus der zentralen Taktversorgung. Für die Adreßleitungen A0 bis A13 stehen hierfür jeweils 14 Eingangsregister und für die Schreib-Leseleitung R/W′ und die Dateneingangsleitung DEIN jeweils ein Eingangsregister zur Verfügung. In der folgenden ersten Pipelinestufe P1 werden die Adressen decodiert. Einige Adreßleitungen, im Beispiel die höchstwertigsten vier Adressen A10 bis A13 sind zur Blockauswahl bestimmt. Sie werden in einem 4:16 Dekoder DK1 zu Blockselektsignalen BS2 dekodiert. Die unteren Adressen A0 bis A9 sollen zur Auswahl innerhalb der mittleren und unteren Hierarchieebene dienen. Dementsprechend werden zwei Adreßpaare in 2:4 Dekodern DK2 zu je vier Z2- und S2-Signalen dekodiert, die der Auswahl einer Zeile bzw. Spalte von 64-Bit-Blöcken dienen soll. Je drei Adreßleitungen werden in 3:8 Dekodern DK3 zu Z1- und S1-Signalen dekodiert, die der Zeilen- und Spaltenauswahl innerhalb der 64-Bit-Blöcke dienen. Das Dateneingangssignal DIN und das Schreib-Lesesignal R/W′ können zur Synchronisation in Registern und einer Gruppe von Verstärkern V1 zwischengespeichert werden.

Am Ausgang der ersten Pipelinestufe P1 und Eingang der zweiten Pipelinestufe P2 ist eine zweite Gruppe von dynamischen Registern D2 angeordnet. Hierzu dienen 16 dynamische Register für die Blockselektsignale BS2, je 4 dynamische Register für die Z2-und S2-Signale, je 8 dynamische Register für die Z1- und S1-Signale und je ein dynamisches Register für das Schreib-Lesesignal R/W′ und das Dateneingangssignal DIN. In der zweiten Pipelinestufe P2 werden die Signale Z2, S2, Z1, S1, R/W′ und DIN verstärkt und zu allen Speicherblöcken SPB verdrahtet. Jedem der 16 Speicherblöcke SPB ist jeweils ein Ein-Ausgangstaktgenerator E/AT zugeordnet. Jedes der Blockselektsignale BS2 wird über einen Inverter I1 zu einem der Ein-Ausgangstaktgeneratoren E/AT verdrahtet. Zusätzlich wird ein vorversetztes Taktsignal PMB aus der zentralen Taktversorgung zu allen EinAusgangstaktgeneratoren E/AT geführt. Aus dem zeitlich vorversetzten Taktsignal PMB und dem Blockselektsignal BS2 werden für den gerade ausgewählten 1K Block Taktsignale PI,PIQ,PI′, PIQ′ zur Ansteuerung der Gruppe von statischen Registern SR und der statischen Register mit Resetschaltung SRR erzeugt. Diese Eingangsregister sind statisch, damit in einem abgewählten 1K Block keine undefinierten Zustände entstehen können. Das Schreib-Lesesignal R/W′ wird in dieser Registerstufe zudem in zwei Signale R und W aufgespalten. Für die vier Z2 Signale werden jeweils statische Register mit Resetschaltung SRR verwendet, die es erlauben die Signale nach Abwahl des Blockes zu desaktivieren.

Im einzelnen ist ein Ein-Ausgangstaktgenerator E/AT wie folgt aufgebaut. Er enthält einen Eingangs- und einen Ausgangstaktgenerator ET, AT, drei Inverter I3, I4, I5, ein Transfergatter TG1 und ein dynamisches Register D3. Das Blockselektsignal BS2 wird auf einen ersten Eingang des Eingangstaktgenerators ET und über den Inverter I3, das Transfergatter T1 und das dynamische Register D3 mit einem ersten Eingang des Ausgangstaktgenerators AT verbunden. Auf einen zweiten Eingang des Eingangstaktgenerators ET wird das zeitlich vorversetzte Signal PMB geschaltet, welches auch über einen lnverter I4 mit einem zweiten Eingang des Ausgangstaktgenerators AT verschaltet ist. Das dynamische Register D3 wird einerseits über den lnverter I4 angesteuert (Signal PMBQQ) und ist andererseits über einer Reihenschaltung von I4 und I5 (Signal PMBQ) mit dem zeitlich vorversetzten Taktsignal PMB verbunden. Das Transfergatter TG1 schließlich ist ebenfalls am Ausgang des Inverters 15 anzuschließen. Der Ausgang des Eingangsregisters ET weist einen ersten Taktausgang mit dem Taktsignal PI, PIQ′ und einen zweiten Taktausgang mit dem Signal PIQ, PI′ auf, während der Ausgangstaktgenerator AT die Signale PO, POQ′ bzw. POQ, PO′ an seinen Taktausgängen führt.

Der in der dritten Pipelinestufe P3 liegende Speicherblock SPB enthält die Gruppe der statischen Register SR, die statischen Register mit Resetschaltung SRR, den 1K Speicherblock 1KB, dynamische Register D4 sowie ein NOR-Gatter NOR1 mit nachfolgendem Inverter I6 zur Zusammenfassung der Datenausgangsleitungen des 1K Speicherblocks 1KB.

Die Verschaltung des Speicherblockes SPB wird hierbei im einzelnen wie folgt vorgenommen. Die vier Z2-Signale Z2 werden über statische Register mit Resetschaltung SRR geführt, die selbst mit Blockselektsignalen BS2 und BS4 angesteuert werden, während für die übrigen Zuleitungen wie die Adreßleitungen A0 bis A9, die Schreib-Leseleitung R/W′ und die Dateneingangsleitung DIN statische Register verwendet werden. Demzufolge werden für die Z2-Signale vier statische Register mit Resetschaltungen benötigt, für die S2-Signale vier statische Register, für die Z1 und S1-Signale jeweils acht statische Register und für das Schreib-Lesesignal R/W′ und das Dateneingangssignal DIN jeweils ein statisches Register. Mit Hilfe eines Inverters I2 und nach folgendem Transfergatter TG2 wird das Schreib-Lesesignal R/W′ in ein Lesesignal R und ein Schreibsignal W aufgespalten. Der Inverter I2 wird hierbei zwischen den beiden Transfergatter des statischen Registers der Schreib-Leseleitung R/W′ angeschlossen. Alle Zuleitungen über die Gruppe der statischen Register mit Resetschaltungen SRR und der Gruppe der statischen Register SR werden auf den 1K-Block 1KB gelegt. Am Ausgang des 1K-Blockes 1KB sind Register D4 für die Ausgangsdaten angebracht. Hier gibt es verschiedene Möglichkeiten, wie die Datenleitungen der 64 Bit-Blöcke günstig hinsichtlich Laufzeit und Flächenbedarf zusammengefaßt werden können. In der Figur 2 werden vier Datenleitungen aus den vier Zeilen von 64 Bit-Blöcken in vier ersten Halbregistern (erster Teil von D4) gespeichert. Diese Signale sind "active high", das heißt nur die Leitung der ausgewählten Zeile kann - bei einer gespeicherten 1 in der ausgewählten Speicherzelle - einen hohen positiven Spannungswert erhalten. Innerhalb des Registers werden die vier Signale durch eine NOR-Verknüpfung in dem NOR-Gatter NOR1 und dem nachfolgenden Inverter I6 zu einem Ausgangssignal zusammengefaßt. Dieses wird in einem zweiten Halbregister (zweiter Teil von D4) gespeichert. Die beiden Ausgangshalbregister D4 werden von Taktsignalen PO, PO′ und POQ, POQ′ angesteuert. Der Ausgang des zweiten Halbregisters D4 ist über ein Widerstandselement W′ mit einem Bezugspotential (in diesem Falle Masse) verbunden, um den Ausgang nichtangewählter Blöcke auf niedrigem Potential zu halten. Das Widerstandselement kann beispielsweise durch einen Feldeffekttransistor (n-Kanal-Typ) realisiert werden, dessen Gateanschluß mit dem Drainanschluß und dem Ausgang von D4 verbunden und dessen Sourceanschluß an das Bezugspotential angeschlossen ist. Die vierte und fünfte Pipelinestufe P4 und P5 dient der weiteren Zusammenfassung der Ausgangsleitungen aus den 16 1K-Blöcken. Hierbei enthält die vierte Pipelinestufe P4 zwei NOR-Gatter NOR2, NOR3 mit jeweils acht Eingängen und einem Ausgang, wobei der Ausgang jeweils auf einen Inverter I7 und I8 geschaltet ist. Zur weiteren Zusammenfassung der zwei Ausgangsleitungen ist am Ausgang von P4 und am Eingang von P5 das dynamische Register D5 angeordnet. Es enthält ein zweifach NAND-Gatter NAND1 mit einem nachfolgenen Inverter I9, wobei dieses Gatter innerhalb des Ausgangsregisters D5 eingefügt ist. Auf das mit den Haupttakten PM, PMQ und PS, PSQ angesteuerte Ausgangsregister D5 folgt ein Ausgangstreiber I10.

Ein dynamisches Register nach D1 bis D5 wird mit Hilfe von zwei Transfergattern und zwei hintereinander geschalteten Invertern aufgebaut, wobei die zwei hintereinander geschalteten Inverter zwischen dem ersten und zweiten Transfergatter angeordnet sind. Innerhalb der dynamischen Register D4 und D5 wird anstelle des einen Inverters jeweils ein NOR-Gatter NOR 1 oder ein NAND-Gatter NAND1 eingefügt.

Ein statisches Register aus der Gruppe der statischen Register SR enthält zwei Transfergatter, einen ersten, zweiten und dritten Inverter. Der erste und zweite Inverter sind hierbei in Serie zwischen dem ersten und zweiten Transfergatter geschaltet, wobei der erste Inverter im Eingangsbereich des statischen Registers und der zweite Inverter im Ausgangsbereich des statischen Registers angeordnet ist. Der dritte Inverter stellt hierbei eine Rückkopplungsverbindung zwischen einem Ausgang des ersten Inverters und einem Eingang desselbigen her.

Die Beschreibung des statischen Registers mit Resetschaltung ist im einzelnen aus der Figur 7 zu entnehmen.

In Figur 2 nicht angegeben sind zusätzliche Steuersignale wie das Chip enable Signal (CE) oder das Output enable Signal (OE). Solche Signale könne je nach Anforderung der Applikation synchron oder asynchron mitverarbeitet werden. Das Output enable Signal kann asynchron auf einen Tristate-Ausgangstreiber wirken. Alternativ kann ein externes oder ein internes durch UND-Verknüpfung aus dem Chip enable Singnal und dem Schreib- Lesesignal abgeleitetes Output enable Signal in Synchron-Registern bis zum Gültigwerden der zugehörigen Ausgangsdaten zwischengespeichert werden und dann synchron auf den Ausgangstreiber wirken. Das Chip enable Signal kann ebenfalls nur auf einzelne Schaltungsteile z.B: den Ausgangstreiber wirken. Möglich ist auch, daß durch das Chip enable Signal oder ein Standby-Signal die zentrale Taktversorgung auf einen definierten Zustand angehalten werden kann.

In Beispiel von Figur 2 müssen bei einem Lesezugriff die Register SRR,SR für Block- Eingangssignale eine Taktperiode vor den Registern D4 für Ausgangsdaten aktiviert werden. Deshalb werden zwei Taktpaare erzeugt.: Ein erstes Taktpaar PI, (PI′), PIQ, (PIQ′) für die Eingangsregister SRR,SR durch Verknüpfung des zeitlich vorversetzten Taktes PMB mit dem Blockselektsignal BS2 und ein zweites Taktpaar PO, (PO′), POQ, (POQ′) für die Ausgangsregister D4 durch eine Verknüpfung des zeitlich vorversetzten Taktes PMB mit dem Blockselektsignal BS4. Da die abschaltbaren Blocktakte nur innerhalb eines 1-K Blocks verteilt werden müßen, kann hier jeweils ein einfaches Zweiphasentaktschema gewählt werden. Um das Blockselektsignal BS4 zu erhalten wird das Blockselektsignal BS2 im 1-K Block in drei Halbregistern (in der Figur 2 mit den Bezugszeichen TG1 und D3 bezeichnet) um anderthalb Taktperioden verzögert. Diese drei Halbregister werden von aus dem Taktsignal PMB erzeugten Takten PMBQ und PMBQQ angesteuert. Die Eingangs-Ausgangstakterzeugung E/AT ist so gestaltet, daß in einem abgewählten 1-K Block jeweils die inneren Halbregister geöffnet und die äußeren, der Peripherie zugewandten Halbregister gesperrt sind. Dadurch werden in Kombination mit den oben erwähnten statischen Eingangsregistern stabile Pegel in abgewählten Blöcken erzielt und die Zusammenfassung der Ausgangsdaten wird vereinfacht. Für größere statische Speicher könnte eine noch tiefere Staffelung mit weiteren abschaltbaren Taktpaaren in Frage kommen.

Figur 3 und Figur 4 enthalten Zeitdiagramme für die Erzeugung der Takte und den Signalverlauf durch die aufeinanderfolgenden Pipelinestufen. Da wie bereits erwähnt ein dynamisches Register, ein statisches Register oder ein statisches Register mit Resetschaltung jeweils ein Transfergatter am Eingang und ein Transfergatter am Ausgang enthält ist es notwendig für jedes Transfergatter jeweils ein zueinander inverses Taktpaar bereitzustellen. Dem zu Folge werden die Gruppe der dynamischen Register D1, D2 und D5 jeweils mit den Taktpaaren PM,PMQ und PS,PSQ beschaltet. Für die Gruppe der statischen Register SR und statischen Register mit Resetschaltung SRR sind dies die Taktpaare PI,PI′ und PIQ, PIQ′ und schließlich für die dynamischen Register D4 die Taktpaare PO,PO′ sowie POQ und POQ′. Da die beiden Transfergatter der Gruppe der statischen Register SR, die der statischen Register mit Resetschaltung SRR und ebenfalls die dynamischen Register D4 jeweils mit inversen Taktsignalen PI,PIQ bzw.PO und POQ angesteuert werden entsprechen sich folgende Taktpaare: PIQ′ und PI, PI′ und PIQ, POQ′ und PO sowie PO′ und POQ. In der Figur 3 ist neben dem Signalverlauf für diese Takte auch die von PM und PMQ sowie PS und PSQ eingezeichnet. In der ersten Zeile von Figur 3 ist der verlauf des Taktes am Takteingang P der zentralen Taktversorgung aufgezeichnet. Wie die hieraus generierten Takte PM, PMQ, PS, PSQ sowie PMB erzeugt werden ist in der Figur 5 näher beschrieben. Ebenfalls wiedergegeben sind die Blockselektsignale BS2 und BS4, wobei das Blockselektsignal BS2 dem Eingangstaktgenerator ET und das Blockselektsignal BS4 dem Ausgangstaktgenerator AT zugeschaltet wird. Die letzten drei Zeilen der Figur 3 schließlich zeigen Z2 Signale am Eingang Z2I sowie am Ausgang Z2Q eines statischen Registers mit Resetschaltung. Das Resetsignal RZ2 schließlich ist ein intern im statischen Register mit Resetschaltung generiertes Signal.

Figur 4 zeigt den Signalverlauf durch die aufeinanderfolgenden Pipelinestufen P1-P5. Hierzu sind in den ersten Zeilen der Figur 4 nochmals die Taktsignale PM,PS, PI und PO aufgezeichnet. In Abhängigkeit hiervon erkennt man den Signalverlauf EIN′,E1′,E2′ und E3′ durch die aufeinanderfolgenden Pipelinestufen P1, P2 und P3. Der Lesevorgang wird durch den Signalverlauf in D3′,D4′ und D0′ wiedergegeben. Ein Beschreiben der Speicherzellen, in der letzten Zeile mit WR′ wiedergegeben, erfolgt zu den gleichen Zeitabschnitten wie ein Lesevorgang D3. In Figur 4 ist der Zeitpunkt des Signals an den Stellen E1′ bis D0′ des Speichers durch Kreuzschraffur eingezeichnet.

Die Pipelinestufe mit der längsten Durchlaufzeit wird bei geeigneter Aufteilung der Decodierschaltungen und Leitungstreiber im allgemeinen der Abschnitt durch die untersten Hierarchieebenen sein, in diesem Beispiel der 1-K Block. Daher ist es ohne Begrenzung der maximalen Taktfrequenz möglich, für die Peripherie ein Pseudo-Zweiphasentaktschema mit verriegelten Master- und Slave- Takten zu wählen. Hierfür können übliche Verfahren zur Erzeugung verriegelter Takte angewandt werden, wie sie beispielsweise in der Veröffentlichung C.Mead.L.Conway: "Introduction to VLSI systems", Edison Wesley, Reading, MA, 1980 in Kapitel 7 beschrieben werden. Dabei darf jedoch die Totzeit zwischen zwei aktiven Taktphasen nicht zu lange werden. Deshalb wurden in der Schaltung nach Figur 5 nicht die Haupttakte selbst gegeneinander verriegelt, sondern es wurden dazu zeitlich vorversetzte Signale verwendet, in Figur 5 sind dies die Signale PM1 statt PM und PSQ1 statt PS.

Figur 5 zeigt die zentrale Taktversorgung, mit einem Takteingang P und fünf Taktausgängen PMB,PMQ,PM,PSQ und PS. Die Taktausgänge PMQ und PM liefern jeweils zueinander inverse Taktsignale ebenso wie die Taktausgänge PSQ und PS. Die zentrale Taktversorgung enthält ein NAND-Gatter NAND2, ein NOR-Gatter NOR4, zwei Transfergatter TG3 und TG4 sowie 28 Inverter. Bei Transfergatter ist der Gateanschluß des n-Kanal-Feldeffekttransistors mit dem positiven Bezugspotenial (VDD) und der Gateanschluß des p-Kanal-Feldeffekttransistors mit dem negativen Bezugspotential (hier Masse) verbunden, so daß beide Transfergatter immer leiten und nur einen Laufzeitausgleich bewirken. Hierbei ist der Takteingang P mit einem ersten Eingang des NAND-Gatters NAND2 und einem ersten Eingang des NOR-Gatters NOR4 verschaltet und an Ausgang des NAND-Gatters NAND2 ist über einen Inverter I12 mit dem zweiten Eingang des NOR-Gatters NOR4 verbunden. Weiterhin ist ein Ausgang des NOR-Gatters NOR4 über einen Inverter I11 mit dem zweiten Eingang des NAND-Gatters NAND2 zu verbinden und am Ausgang des NAND-Gatters NAND2 ist über drei sequentiell hintereinander geschaltete Inverter der erste Ausgang der zentralen Taktversorgung PMB angeschlossen. Weiterhin ist der Ausgang des NAND-Gatters NAND2 über das Transfergatter TG3 mit einer ersten Gruppe von sechs sequentiell hintereinander geschalteten Invertern mit dem zweiten Ausgang der zentralen Taktversorgung PMQ verbunden. Am Ausgang des Inverters I12 ist weiterhin eine zweite Gruppe von sechs sequentiell hintereinander geschalteten Invertern angeschlossen, an deren Ende der dritte Taktausgang PM anzuschließen ist. Eine dritte Gruppe von sechs sequentiell hintereinander geschalteten Invertern ist zwischen dem vierten Taktausgang PSQ und Ausgang des Inverters I11 verschaltet und schließlich ist der Ausgang des NOR-Gatters NOR 4 über das Transfergatter T4 mit einer daran anschließenden vierten Gruppe von sechs sequentiell hintereinander geschalteten Invertern mit dem fünften Taktausgang PS der zentralen Taktversorgung verschaltet.

Figur 6 zeigt den Aufbau des Ein-Ausgangsgenerators der jeweils einen Eingangs- und einen Ausgangstaktgenerator enthält. Der Eingangstaktgenerator beinhaltet ein erstes NAND-Gatter NAND3, fünf Inverter und ein Transfergatter TG5 während der Ausgangstaktgenerator ein weiteres NAND-Gatter NAND4 weitere fünf Inverter und ein zweites Transfergatter TG6 beinhaltet. Der erste Eingang des NAND-Gatters NAND3 ist hierbei mit dem ersten Ausgang der zentralen Taktversorgung PMB zu verschalten, während auf den zweiten Eingang von NAND3 das Blockselektsignal BS2 zu schalten ist. Am Ausgang des NAND-Gatters NAND3 wird über eine erste Gruppe von drei hintereinander geschalteten Invertern der erste Taktausgang PI (PIQ′) des Eingangstaktgenerator und über ein Transfergatter TG5 mit einer daran angeschlossenen ersten Gruppe von zwei hintereinander geschalteten Invertern der zweite Taktausgang PIQ (PI′) des Eingangstaktgenerators gebildet. Der erste Eingang des NAND4 Gatters des Ausgangstaktgenerators ist über den Inverter I4 (siehe Figur 2) mit dem ersten Taktausgang PMB der zentralen Taktversorgung verbunden, während auf den zweiten Eingang von NAND4 das Blockselektsignal BS4 zuschalten ist. Am Ausgang des NAND-Gatters NAND4 ist einerseits über ein Transfergatter TG6 und daran angeschlossenen zwei Invertern der erste Ausgang PO (POQ′) des Ausgangstaktgenerators vorgesehen und über eine Gruppe von drei hintereinander geschalteten Invertern der zweite Taktausgang POQ (PO′).

Die in den Figuren 5 und 6 angegebenen Zahlenwerte beziehen sich auf Dimensionierungsvorschläge, wobei die erste Ziffer die Kanalweite eines N-Kanalfeldeffekttransistors und die zweite Ziffer die Kanalweite eines P-Kanaleffekttransistors angibt. Hier noch bedeutet die Angabe von 10/23 der Inverter I11 und I12, daß die Kanalweite des N-Kanalfeldeffekttransistors 10»m und die des P-Kanaleffekttransistors 23»m beträgt.

Figur 7 zeigt ein statisches Register mit Resetschaltung, wobei die Resetschaltung zwischen zwei Transfergatter TG7 und TG8 angeordnet ist. Auf den Eingang des statischen Registers mit Resetschaltung ist ein Z2I Signal angelegt, während am Ausgang das Signal Z2Q abgegriffen werden kann. Die Resetschaltung enthält 7 Inverter, ein NOR-Gatter NOR 5 und ein NAND-Gatter NAND5. Auf das NOR-Gatter NOR5 wird das Blockselektsignal BS2 und das Blockselektsignal BS4 geschaltet und ein dritter Eingang des NOR-Gatters NOR5 ist über eine Gruppe von drei hintereinander geschalteten Invertern I13,I14 und I15 mit dem Blockselektsignal BS4 verbunden. Der Ausgang des NOR-Gatters NOR5 wird über den Inverter I16 mit einem ersten Eingang des NAND-Gatters NAND5 verschaltet, während der zweite Eingang des NAND-Gatter NAND5 über das Transfergatter TG7 mit dem Eingang des statischen Registers mit Resetschaltung verbunden ist. Der Ausgang des NAND-Gatters NAND5 wird über den Inverter I17 auf den ersten Eingang des NAND-Gatters NAND5 rückgekoppelt und ist über den Inverter I18, dem nachfolgenden Transfergatter TG8 und dem Inverter I19 mit dem Ausgang des statischen Registers mit Resetschaltung verbunden. Die Transfergatter TG7 und TG8 werden jeweils mit zwei Taktpaaren PI,PI′ und PIQ, PIQ′ getaktet.

## Patentansprüche

1. Ein aus Speicherzellen hierarchisch aufgebauter Speicher, wobei der Speicher in untere, mittlere und höhere Hierarchieebenen aufgeteilt ist und ein Element der ersten Hierarchieebene (H0) eine Speicherzelle ist, ein Element der zweiten eine Hierarchieebene (H1) eine Gruppe von Speicherzellen ist und ein Element jeder nächsthöheren Hierarchieebene aus einer Gruppe von Elementen der nächstniederen Hierarchieebene aufgebaut ist, daß jeder Hierarchieebene eine Spalten- und Zeilenschaltung zum Ansteuern, Lesen und Schreiben der Elemente der Hierarchieebene zugeordnet ist, **dadurch gekenn****zeichnet**, daß flächenaufwendige Schaltungsteile der Spalten- und Zeilenschaltungen der niederen Hierarchieebenen in höheren Hierarchieebenen realisiert sind, daß in den mittleren und höheren Hierarchieebenen mehrere Pipelinestufen (P1...P5) zwischen den Spalten-und Zeilenschaltungen benachbarter oberer und unterer Hierarchieebenen angeordnet sind , wobei die Pipelinestufen teilweise der oberen und teilweise der unteren Hierarchieebene angehören, daß der Speicher eine zentrale Taktversorgung zur Erzeugung von Haupttakten (PM, PMQ, PS, PSQ, PMB) aufweist, daß jedem Element der unteren Hierarchieebene je ein Ein-Ausgangstaktgenerator (E/AT) zur Erzeugung von Lokaltakten (PMBQ, PMBQQ, PI, PI′, PO, PO′) zugeordnet ist, daß die Haupttakte den Pipelinestufen der oberen Hierarchieebene und den Ein/Ausgangstaktgeneratoren der unteren Hierarchieebene zugeführt werden, und daß die Lokaltakte den Pipelinestufen der unteren Hierarchieebene zugeführt werden.

2. Ein aus Speicherzellen hierarchisch aufgebauter Speicher nach Anspruch 1, **dadurch gekennzeichnet**, daß die Speicherzellen statische Speicherzellen sind und daß jede Speicherzelle mit einer Datenleitung zum Einlesen von Informationen in die Speicherzelle und mit einer Datenleitung zum Auslesen von Informationen aus der Speicherzelle ausgestattet ist.

3. Ein aus Speicherzellen hierarchisch aufgebauter Speicher nach Anspruch 1 oder 2, **dadurch gekennzeichnet,** daß Decoderschaltungen für Spaltenadress- und Zeilenadressleitungen in der Spalten- und Zeilenschaltung der niederen Hierarchieebene (H1) in einer höheren Hierarchieebene (H3) realisiert sind.

4. Ein aus Speicherzellen hierarchisch aufgebauter Speicher nach einem der Ansprüche 1 bis 3, **dadurch gekennzeichnet**, daß die höhere Hierarchieebene (H3) fünf sequentiell hintereinander angeordnete Pipelinestufen (P1...P5) enthält, daß erste dynamische Register (D1) an Eingängen der ersten Pipelinestufe (P1), zweite dynamische Register (D2) zwischen Ausgängen der ersten Pipelinestufe (P1) und Eingängen der zweiten Pipelinestufe (P2), vierte dynamische Register (D4) zwischen Ausgängen der dritten Pipelinestufe (P3) und Eingängen der vierten Pipelinestufe (P4) und fünfte dynamische Register (D5) zwischen Ausgängen der vierten Pipelinestufe (P4) und Eingängen der fünften Pipelinestufe (P5) angeordnet sind, daß statische Register (SR) und statische Register mit Resetschaltungen (SRR) zwischen Ausgängen der zweiten - (P2) und Eingängen der dritten Pipelinestufe (P3) vorhanden sind, daß die erste Pipelinestufe Decoderschaltungen (DK1...DK3) für die Decodierung der Zeilen- und Spaltenadressleitungen und Verstärkerschaltungen (V1) für Schreib-, Lese- und Dateneingangsleitungen (R/W′,DIN) enthält, daß die zweite Pipelinestufe (P2) Verstärkerschaltungen (V2) für die Zeilen- und Spaltenadressieitungen (Z1,Z2,S1,S2) und für die Schreib-Lese und Dateneingangsleitungen (R/W′,DIN) enthält, daß die dritte Pipelinestufe (P3) Elemente der nächstniederen Hierarchiestufe (H2) und einen zu jedem Element zugeordneten Ein-Ausgangstaktgenerator (E/AT) enthält, wobei die höchstwertigsten decodierten Adressbits (A10...A13) als Blockselektsignale (BS2) mit den Ein- Ausgangstaktgeneratoren (E/AT) verbunden sind, daß die dritte und vierte Pipelinestufe (P3,P4) mehrere NOR-Gatter (NOR1...NOR3) und die fünfte Pipelinestufe ein NAND-Gatter (NAND1) enthält, die jeweils der Zusammenfassung von Datenausgangsleitungen (DOUT) der Elemente der nächstniederen Hierarchieebene (H2) dienen, und daß die dynamischen Register (D1,D2,D4,D5) zur Steuerung mit einem zweiten, dritten vierten und fünften Taktausgang (PM,PMQ,PS,PSQ) der zentralen Taktversorgung verbunden sind.

5. Ein aus Speicherzellen hierarchisch aufgebauter Speicher, nach einem der Ansprüche 1 bis 4 **dadurch gekennzeichnet**, daß die zentrale Taktversorgung einen Takteingang (P) und fünf Taktausgänge (PMB,PM,PMQ,PS,PSQ), ein zweites NAND-Gatter (NAND2), ein viertes NOR-Gatter (NOR4), ein drittes und viertes Transfergatter (TG3,TG4) und 28 Inverter enthält, daß der Takteingang (P) mit einem ersten Eingang des zweiten NAND-Gatters (NAND2) und mit einem ersten Eingang des vierten NOR-Gatters (NOR4) verschaltet ist, daß ein Ausgang des zweiten NAND-Gatters (NAND2) über einen zwölften Inverter (I12) mit einem zweiten Eingang des vierten NOR-Gatters (NOR4) verschaltet ist, daß ein Ausgang des vierten NOR-Gatters (NOR4) über einen elften Inverter (I11) mit dem zweiten Eingang des zweiten NAND-Gatters (NAND2) verbunden ist, daß der Ausgang des zweiten NAND-Gatters (NAND2) über drei sequentiell hintereinander geschaltete Inverter mit dem ersten Taktausgang der zentralen Taktversorgung (PMB) verschaltet ist, daß der Ausgang des zweiten NAND-Gatters (NAND2) über das dritte Transfergatter (TG3) und über eine daran anschließende erste Gruppe von sechs sequentiell hintereinander geschalteten Invertern mit dem zweiten Taktausgang (PMQ) der zentralen Taktversorgung verbunden ist, daß zwischen dem Ausgang des zwölften Inverters (I12) und dem dritten Taktausgang (PN) der zentralen Taktversorgung eine zweite Gruppe von sechs sequentiell hintereinander geschalteten Invertern vorhanden ist, daß eine dritte Gruppe von sechs sequentiell hintereinander geschalteten Invertern zwischen dem vierten Taktausgang (PSQ) und einem Ausgang des elften Inverters (I11) verschaltet ist und daß der Ausgang des vierten NOR-Gatters (NOR4) über ein viertes Transfergatter (TG4) mit einer daran anschließenden vierten Gruppe von sechs sequentiell hintereinander geschalteten Invertern mit dem fünften Taktausgang (PS) der zentralen Taktversorgung verbunden ist.

6. Ein aus Speicherzellen hierarchisch aufgebauter Speicher, nach Anspruch 4 oder 5, **dadurch gekennzeichnet**, daß jeder Ein- Ausgangstaktgenerator (E/AT) einen Eingangs- und einen Ausgangstaktgenerator (ET,AT) einen dritten, vierten und fünften Inverter (I3,I4,I5), ein drittes dynamisches Register (D3) und ein Transfergatter (TG1) enthält, und weiterhin einen Taktsteuereingang, einen Blockselekteingang, sowie vier Taktausgänge aufweist, daß der Blockselekteingang mit dem ersten Eingang des Eingangstaktgenerators (ET) und über den dritten Inverter (I3), das erste Transfergatter (TG1) und das dritte dynamische Register (D3) mit einem ersten Eingang des Ausgangstaktgenerators (AT) verbunden ist, daß der Taktsteuereingang mit einem zweiten Eingang des Eingangstaktgenerator (ET) und über einen vierten Inverter (I4) mit einem zweiten Eingang des Ausgangsgenerators (AT) verschaltet ist, daß der Ausgang des vierten Inverters (I4) weiterhin mit einem ersten Steueranschluß des dritten dynamischen Registers (D3) und über einen fünften Inverter (I5) mit einem zweiten Steueranschluß des dritten dynamsichen Registers (D3) gemeinsam mit einem Steueranschluß des ersten Transfergatters (TG1) verschaltet ist und daß der Ein-Ausgangstaktgenerator (E/AT) jeweils einen ersten und zweiten Taktausgang (P1,PTQ; PO,POQ) aufweist.

7. Ein aus Speicherzellen hierarchisch aufgebauter Speicher, nach Anspruch 6, **dadurch gekennzeichnet**, daß der Eingangstaktgenerator (ET) ein drittes NAND-Gatter (NAND3), fünf Inverter und ein fünftes Tranfergatter (TG5) und der Ausgangstaktgenerator (AT) ein viertes NAND-Gatter (NAND4) weitere fünf Inverter und ein sechstes Transfergatter (TG6) enthält, daß der erste Eingang des Eingangstaktgenerators (ET) mit einem ersten Eingang des dritten NAND-Gatters (NAND3), der zweite Eingang des Eingangstaktgenerators (ET) mit einem zweiten Eingang des dritten NAND-Gatters (NAND3) verbunden ist, daß ein Ausgang des dritten NAND-Gatters (NAND3) über eine erste Gruppe von drei hintereinander geschalteten Invertern den ersten Taktausgang (PI,PIQ′) des Eingangstaktgenerators (ET) und über ein fünftes Transfergatter (TG5) mit einer daran angeschlossenen ersten Gruppe von zwei hintereinander geschalteten Invertern den zweiten Taktausgang (PIQ,PI′) des Eingangsstaktgenerators (ET) bildet, daß der erste Eingang des Ausgangsgenerators (AT) mit einem ersten Eingang des vierten NAND-Gatters (NAND4) und der zweite Eingang des Ausgangstaktgenerators (AT) mit einem zweiten Eingang des vierten NAND-Gatters (NAND4) verbunden ist, daß ein Ausgang des vierten NAND-Gatters (NAND4) über das sechste Tranfergatter (TG6) und daran angeschlossene zweite Gruppe von zwei hintereinander geschalteten Invertern den ersten Taktausgang (PO,POQ′) des Ausgangstaktgenerators (AT) und über einer zweiten Gruppe von drei hintereinander geschaltenen Invertern den zweiten Taktausgang (POQ,PO′) des Ausgangstaktgenerators (AT) darstellt.

8. Ein aus Speicherzellen hierarchisch aufgebauter Speicher, nach einem der vorhergehenden Ansprüche, **dadurch gekennzeichnet**, daß ein dynamisches Register zwei Transfergatter und zwei hintereinander geschaltete Inverter enthält, daß die zwei hintereinander geschalteten Inverter zwischen dem ersten und zweiten Transfergatter angeordnet sind.

9. Ein aus Speicherzellen hierarchisch aufgebauter Speicher, nach einem der vorhergehenden Ansprüche, **dadurch gekennzeichnet**, daß ein statisches Register zwei Transfergatter, einen ersten, zweiten und dritten Inverter enthält, daß der erste und zweite Inverter in Serie zwischen dem ersten und zweiten Transfergatter geschaltet ist, wobei der erste Inverter und das erste Transfergatter im Eingangsbereich und das zweite Transfergatter und der zweite Inverter im Ausgangsbereich des statischen Registers angeordnet ist, und daß der dritte Inverter eine Rückkopplungsverbindung zwischen einem Ausgang des ersten Inverters und einem Eingang des ersten Inverters darstellt.

10. Ein aus Speicherzellen hierarchisch aufgebauter Speicher, nach einem der vorhergehenden Ansprüche, **dadurch gekennzeichnet**, daß in einem statischen Register mit Resetschaltung, die Resetschaltung zwischen einem siebten und achten Transfergatter (TG7,TG8) angeordnet ist, daß die Resetschaltung zwei Blockselekteingänge, ein fünftes NOR-Gatter (NOR5), einen dreizehnten bis achtzehnten Inverter (I13...I19) und ein fünftes NAND-Gatter (NAND5) enthält, daß der erste Blockselekteingang auf einen ersten Eingang des fünften NOR-Gatters und der zweite Blockselekteingang mit einem zweiten Eingang und über den dreizehnten, vierzehnten und fünfzehnten hintereinander geschalteten Inverter (I13...I15) mit einem dritten Eingang des fünften NOR-Gatters (NOR5) verschaltet ist, daß ein Ausgang des fünften NOR-Gatters (NOR5) über einen sechzehnten Inverter (I16) mit einem ersten Eingang des fünften NAND-Gatters (NAND5) verschaltet ist, daß ein Ausgang des siebten Transfergatters (TG7) auf einen zweiten Eingang des fünften NAND-Gatters (NAND5) geschaltet ist, daß ein Ausgang des fünften NAND-Gatters (NAND5) über den siebzehnten Inverter (I17) auf den zweiten Eingang des fünften NAND-Gatters rückkoppelt ist und daß der Ausgang des fünften NAND-Gatters (NAND5) über den achtzehnten Inverter (I18) mit dem achten Transfergatter (TG8) und dem daran angeschlossenen neunzehnten Inverter (I19) verschaltet ist.

11. Ein aus Speicherzellen hierarchisch aufgebauter Speicher nach einem der vorhergehenden Ansprüche, **dadurch gekennzeichnet**, daß der Speicher ein 16k-Speicher ist, der in der höheren Hierarchieebene (H3) in 16 x 1K Blöcke aufgeteilt ist, wobei ein 1K-Block aus 16 Blöcken zu je 64 Bit sowie einem Ein- Ausgangstaktgenerator (E/AT) aufgebaut ist, daß dem Speicher Adressleitungen (A0-A13), eine Schreibleseleitung (R/W′), eine Datenein- (DIN) und Datenausgangsleitung (DOUT) und einen Takteingang (PMB) zugeordnet ist, daß die obersten Adressen (A10-A13) über einen 4:16 Adressdecoder (DK1) in der ersten Pipelinestufe (P1) zu Blockselektsignalen (BS2) decodiert werden, die über erste Inverter (I1) auf je einen Blockselekteingang des zugehörigen Ein-Ausgangsgenerators (E/AT) geschaltet sind, daß die mittleren Adressen (A6-A9) über zwei 2:4 Decoder (DK2) in je vier Zeilen und Spaltenadressleitungen (Z2,S2) decodiert werden, die der Auswahl von Zeilen bzw. Spalten von 64 Bitblöcken dienen, daß die unteren Adressen (A0-A5) über zwei 3:8 Decoder (DK3) in die acht Zeilen-und Spaltenadressleitung (Z1,S1) decodiert werden, die der Auswahl einer Zeile- bzw. Spalte innerhalb der 64 Bitblöcke dient, daß die Verstärkerschaltungen (V2) für die unteren und mittleren decodierten Zeilen- und Spaltenadressleitungen in der zweiten Pipelinestufe (P2) und die Verstärkerschaltungen (V1,V2) für die Schreib-Leseleitung (R/W′) und für Dateneingangsleitung (DIN) in der ersten und zweiten Pipelinestufe (P1,P2) aus je zwei hintereinander geschalteten Invertern besteht, daß die vier Zeilenadressleitungen (Z2) für das Auswählen einer Zeile von 64 Bitblöcken über je ein statisches Register mit Resetschaltungen (SRR) zu jedem 1 K-Block verbunden ist und die vier Spaltenleitungen (S2) zur Auswahl einer Spalte von 64 Bitblöcken, die acht Zeilen und acht Spaltenleitungen (Z1,S1) die zur Auswahl von Zeilen bzw. Spalten innerhalb der 64 Bitblöcke dienen über je ein statisches Register (SR) zu jedem 1 K-Block geschaltet sind, daß die Schreib-Leseleitung (R/W′) am Eingang der dritten Pipelinestufe (P3) in eine Schreib- und eine Leseleitung (R,W) aufgespalten wird, wobei die Leseleitung (R) über jeweils ein statisches Register zu einem 1K-Block und die Schreibleitung (W) über jeweils ein am Ausgang des ersten Transfergatters des zugehörigen statischen Registers über einen Inverter mit nachfolgenden Transfergatter mit dem 1-K Block verschaltet ist, daß die vier Zeilen der Datenleitungen der 64 Bitblöcke über erste NOR-Gatter (NOR1) mit 4 Eingängen und einem Ausgang zusammengefaßt werden, wobei das erste NOR-Gatter (NOR1) innerhalb des vierten dynamischen Registers (D4) am Ausgang der dritten und am Eingang der vierten Pipelinestufe (P3,P4) angeordnet ist, daß ein Widerstandselement (W′) mit einem ersten Anschluß zwischen dem Ausgang der dritten Pipelinestufe (P3) und Eingang der vierten Pipelinestufe (P4) und mit einem zweiten Anschluß mit einem Bezugspotential (VSS) verschaltet ist, daß jeweils 8 der 16 Datenleitungen der 64 Bitblöcke über ein zweites, drittes NOR-Gatter (NOR2,NOR3) mit 8 Eingängen und einem Ausgang zusammengefaßt werden, wobei jeweils ein NOR-Gatter (NOR2,NOR3) mit angeschlossenem Inverter (I7,I8) in der vierten Pipelinestufe (P4) angeordnet ist und die Ausgänge dieser zwei NOR-Gatter (NOR2,NOR3) mit einem ersten NAND-Gatter (NAND1) mit zwei Eingängen und einem Ausgang weiter zusammengefaßt werden, wobei das erste NAND-Gatter (NAND1) innerhalb des fünften dynamischen Registers (D5) am Ausgang der vierten und Eingang der fünften Pipelinestufe (P4,P5) angeordnet ist, daß die zentrale Taktversorgung mit einem zweiten bis fünften Taktausgang (PMQ,PM,PSQ,PS) mit den ersten, zweiten, vierten und fünften Register (D1,D2,D3,D4,D5) verbunden ist und der erste und zweite Taktausgang (PI,PI′;PIQ,PIQ′) des Eingangstaktgenerators (ET) mit den statischen Registern (SR) und den statischen Registern mit Resetschaltung (SRR) verschaltet ist, während der erste und zweite Taktausgang (PO,PO′;POQ,POQ′) an den vierten dynamischen Registern (D4) angeschlossen ist.

12. Ein aus Speicherzahlen hierarchisch aufgebauter Speicher nach einem der vorhergehenden Ansprüchen, **dadurch gekennzeichnet**, daß ein Transfergatter aus einem Feldeffekttransister ersten Leitungstyps und einem Feldeffekttransister zweiten Leitungstyps aufgebaut ist, daß der Feldtransister ersten Leitungstyps parallel mit dem Feldeffekttransister zweiten Leitungstyps verschaltet ist und ein Gateanschluß des Feldeffekttransisters zweiten Leitungstyps den zweiten Steuereingang und ein Gateanschluß des Feldeffekttransisters ersten Leitungstyps den ersten Steuereingang eines Transfergatters bilden.

13. Ein aus Speicherzellen hierarchisch aufgebauter Speicher nach Anspruch 12, **dadurch gekennzeichnet**, daß ein Feldeffekttransister ersten Leitungstyps ein n-Kanal Feldeffekttransister und ein Feldeffekttransister zweiten Leitungstyps ein p-Kanal Feldeffekttransister ist.

## Claims

1. A memory hierarchically constructed from memory cells, the memory being divided into lower, middle and higher hierarchical levels, and one element of the first hierarchical level (H0) being a memory cell, one element of the second hierarchical level (H1) being a group of memory cells and one element of each next-higher hierarchical level being constructed from a group of elements of the next-lower hierarchical level, such that each hierarchical level is assigned a column and line circuit for activating, reading and writing the elements of the hierarchical level, characterized in that high-area circuit elements of the column and line circuits of the lower hierarchical levels are realized on higher hierarchical levels, in that on the middle and higher hierarchical levels a plurality of pipeline stages (P1...P5) are arranged between the column and line circuits of neighbouring upper and lower hierarchical levels, the pipeline stages belonging partly to the upper hierarchical level and partly to the lower hierarchical level, in that the memory has a central clock supply for the generation of master clocks (PM, PMQ, PS, PSQ, PMB), in that each element of the lower hierarchical level is assigned its own input/output-clock generator (E/AT) for the generation of local clocks (PMBQ, PMBQQ, PI, PI′, PO, PO′), in that the master clocks are fed to the pipeline stages of the upper hierarchical level and to the input/output-clock generators of the lower hierarchical level, and in that the local clocks are fed to the pipeline stages of the lower hierarchical level.

2. A memory hierarchically constructed from memory cells according to Claim 1, characterized in that the memory cells are static memory cells and in that each memory cell is equipped with a data line for reading information into the memory cell and with a data line for reading information out of the memory cell.

3. A memory hierarchically constructed from memory cells according to Claim 1 or 2, characterized in that decoder circuits for column-address and line-address lines are realized in the column and line circuit of the lower hierarchical level (H1) on a higher hierarchiqal level (H3).

4. A memory hierarchically constructed from memory cells according to one of Claims 1 to 3, characterized in that the higher hierarchical level (H3) includes five sequentially series-connected pipeline stages (P1...P5), in that first dynamic registers (D1) are arranged at inputs of the first pipeline stage (P1), second dynamic registers (D2) are arranged between outputs of the first pipeline stage (P1) and inputs of the second pipeline stage (P2), fourth dynamic registers (D4) are arranged between outputs of the third pipeline stage (P3) and inputs of the fourth pipeline stage (P4) and fifth dynamic registers (D5) are arranged between outputs of the fourth pipeline stage (P4) and inputs of the fifth pipeline stage (P5), in that there are static registers (SR) and static registers with reset circuits (SRR) between outputs of the second pipeline stage (P2) and inputs of the third pipeline stage (P3), in that the first pipeline stage includes decoder circuits (DK1...DK3) for the decoding of the line-address and column-address lines and amplifier circuits (V1) for writing, reading and data-input lines (R/W′, DIN), in that the second pipeline stage (P2) includes amplifier circuits (V2) for the line-address and column-address lines (Z1, Z2, S1, S2) and for the writing/reading and data-input lines (R/W′, DIN), in that the third pipeline stage (P3) includes elements of the next-lower hierarchical stage (H2) and an input/output-clock generator (E/AT) assigned to each element, the most-significant decoded address bits (A10...A13) being connected as block-select signals (BS2) to the input/output-clock generators (E/AT), in that the third pipeline stage (P3) and fourth pipeline stage (P4) include a plurality of NOR gates (NOR1...NOR3) and the fifth pipeline stage includes a NAND gate (NAND1), which respectively serve for combining data-output lines (DOUT) of the elements of the next-lower hierarchical level (H2), and in that the dynamic registers (D1, D2, D4, D5) are connected for control purposes to a second, third, fourth and fifth clock output (PM, PMQ, PS, PSQ) of the central clock supply.

5. A memory hierarchically constructed from memory cells according to one of Claims 1 to 4, characterized in that the central clock supply includes a clock input (P) and five clock outputs (PMB, PM, PMQ, PS, PSQ), a second NAND gate (NAND2), a fourth NOR gate (NOR4), a third and fourth transfer gate (TG3, TG4) and 28 inverters, in that the clock input (P) is wired to a first input of the second NAND gate (NAND2) and to a first input of the fourth NOR gate (NOR4), in that an output of the second NAND gate (NAND2) is wired via a twelfth inverter (I12) to a second input of the fourth NOR gate (NOR4), in that an output of the fourth NOR gate (NOR4) is connected via an eleventh inverter (I11) to the second input of the second NAND gate (NAND2), in that the output of the second NAND gate (NAND2) is wired via three sequentially series-connected inverters to the first clock output of the central clock supply (PMB), in that the output of the second NAND gate (NAND2) is connected via the third transfer gate (TG3) and via an adjoining first group of six sequentially series-connected inverters to the second clock output (PMQ) of the central clock supply, in that between the output of the twelfth inverter (I12) and the third clock output (PM) of the central clock supply there is a second group of six sequentially series-connected inverters, in that a third group of six sequentially series-connected inverters is wired between the fourth clock output (PSQ) and an output of the eleventh inverter (I11) and in that the output of the fourth NOR gate (NOR4) is connected via a fourth transfer gate (TG4) by an adjoining fourth group of six sequentially series-connected inverters to the fifth clock output (PS) of the central clock supply.

6. A memory hierarchically constructed from memory cells according to Claim 4 or 5, characterized in that each input/output-clock generator (E/AT) includes an input-clock generator (ET) and an output-clock generator (AT), a third, fourth and fifth inverter (I3, I4, I5), a third dynamic register (D3) and a transfer gate (TG1), and furthermore has a clock-control input, a block-select input, and also four clock outputs, in that the block-select input is connected to the first input of the input-clock generator (ET) and via the third inverter (I3), the first transfer gate (TG1) and the third dynamic register (D3) to a first input of the output clock generator (AT), in that the clock-control input is wired to a second input of the input-clock generator (ET) and via a fourth inverter (I4) to a second input of the output generator (AT), in that the output of the fourth inverter (I4) is furthermore wired to a first control terminal of the third dynamic register (D3) and via a fifth inverter (I5) to a second control terminal of the third dynamic register (D3) together with a control terminal of the first transfer gate (TG1) and in that the input/output-clock generator (E/AT) respectively has a first clock output (P1, PTQ) and a second clock output (PO, POQ).

7. A memory hierarchically constructed from memory cells according to Claim 6, characterized in that the input-clock generator (ET) includes a third NAND gate (NAND3), five inverters and a fifth transfer gate (TG5) and the output-clock generator (AT) contains a fourth NAND gate (NAND4), a further five inverters and a sixth transfer gate (TG6), in that the first input of the input-clock generator (ET) is connected to a first input of the third NAND gate (NAND3), the second input of the input-clock generator (ET) is connected to a second input of the third NAND gate (NAND3), in that an output of the third NAND gate (NAND3) forms the first clock output (PI, PIQ′) of the input-clock generator (ET) via a first group of three series-connected inverters and forms the second clock output (PIQ, PI′) of the input-clock generator (ET) via a fifth transfer gate (TG5) with an adjoining first group of two series-connected inverters, in that the first input of the output generator (AT) is connected to a first input of the fourth NAND gate (NAND4) and the second input of the output-clock generator (AT) is connected to a second input of the fourth NAND gate (NAND4), in that an output of the fourth NAND gate (NAND4) represents the first clock output (PO, POQ′) of the output-clock generator (AT) via the sixth transfer gate (TG6) and an adjoining second group of two series-connected inverters and represents the second clock output (POQ, PO′) of the output-clock generator (AT) via a second group of three series-connected inverters.

8. A memory hierarchically constructed from memory cells according to one of the preceding claims, characterized in that a dynamic register includes two transfer gates and two series-connected inverters and in that the two series-connected inverters are arranged between the first transfer gate and second transfer gate.

9. A memory hierarchically constructed from memory cells according to one of the preceding claims, characterized in that a static register includes two transfer gates, a first, second and third inverter, in that the first inverter and second inverter are connected in series between the first transfer gate and second transfer gate, the first inverter and the first transfer gate being arranged in the input region and the second transfer gate and the second inverter being arranged in the output region of the static register, and in that the third inverter represents a coupling-back connection between an output of the first inverter and an input of the first inverter.

10. A memory hierarchically constructed from memory cells according to one of the preceding claims, characterized in that, in a static register with reset circuit, the reset circuit is arranged between a seventh transfer gate (TG7) and eighth transfer gate (TG8), in that the reset circuit includes two block-select inputs, a fifth NOR gate (NOR5), a thirteenth to nineteenth inverter (I13...I19) and a fifth NAND gate (NAND5), in that the first block-select input is wired to a first input of the fifth NOR gate and the second block-select input is wired to a second input and via the thirteenth, fourteenth and fifteenth series-connected inverters (I13...I15) to a third input of the fifth NOR gate (NOR5), in that an output of the fifth NOR gate (NOR5) is wired via a sixteenth inverter (I16) to a first input of the fifth NAND gate (NAND5), in that an output of the seventh transfer gate (TG7) is connected to a second input of the fifth NAND gate (NAND5), in that an output of the fifth NAND gate (NAND5) is coupled back via the seventeenth inverter (I17) to the second input of the fifth NAND gate and in that the output of the fifth NAND gate (NAND5) is wired via the eighteenth inverter (I18) to the eighth transfer gate (TG8) and the adjoining nineteenth inverter (I19).

11. A memory hierarchically constructed from memory cells according to one of the preceding claims, characterized in that the memory is a 16K memory which is divided on the higher hierarchical level (H3) into 16 x 1K blocks, a 1K block being constructed from 16 blocks of 64 bits each and an input/output-clock generator (E/AT), in that the memory is assigned address lines (A0-A13), a reading/writing line (R/W′), a data-input line (DIN) and data-output line (DOUT) and a clock input (PMB), in that the uppermost addresses (A10-A13) are decoded via a 4:16 address decoder (DK1) in the first pipeline stage (P1) to give block-select signals (BS2), which are connected via first inverters (I1) to an own block-select input of the associated input/output-clock generator (E/AT), in that the middle addresses (A6-A9) are decoded via two 2:4 decoders (DK2) into four line-address and column-address lines (Z2, S2) each, which serve for the selection of lines or columns of 64-bit blocks, in that the lower addresses (A0-A5) are decoded via two 3:8 decoders (DK3) into the eight line-address and column-address lines (Z1, S1), which serve for the selection of a line or column within the 64-bit blocks, in that the amplifier circuits (V2) for the lower and middle decoded line-address and column-address lines in the second pipeline stage (P2) and the amplifier circuits (V1, V2) for the writing/reading line (R/W′) and for the data-input line (DIN) in the first pipeline stage (P1) and second pipeline stage (P2) each comprise two series-connected inverters, in that the four line-address lines (Z2) for the selection of a line of 64-bit blocks are connected via an own static register with reset circuits (SRR) to each 1K block and the four column lines (S2) for the selection of a column of 64-bit blocks, the eight line lines (Z1) and eight column lines (S1), which serve for the selection of lines and columns within the 64-bit blocks, are connected via an own static register (SR) to each 1K block, in that the reading/writing line (R/W′) is divided at the input of the third pipeline stage (P3) into a reading line (R) and a writing line (W), the reading line (R) being wired via in each case a static register to a 1K block and the writing line (W) being wired via in each case an output of the first transfer gate of the associated static register via an inverter with following transfer gate with the 1K block, in that the four lines of the data lines of the 64-bit blocks are combined via first NOR gates (NOR1) with 4 inputs and an output, the first NOR gate (NOR1) being arranged within the fourth dynamic register (D4) at the output of the third pipeline stage (P3) and at the input of the fourth pipeline stage (P4) in that a resistance element (W′) is wired by a first terminal between the output of the third pipeline stage (P3) and the input of the fourth pipeline stage (P4) and is wired by a second terminal to a reference potential (VSS), in that in each case 8 of the 16 data lines of the 64-bit blocks are combined via a second NOR gate (NOR2) and third NOR gate (NOR3) with 8 inputs and one output, in each case one NOR gate (NOR2, NOR3) with connected inverter (I7, I8) being arranged in the fourth pipeline stage (P4) and the outputs of these two NOR gates (NOR2, NOR3) being further combined with a first NAND gate (NAND1) with two inputs and one output, the first NAND gate (NAND1) being arranged within the fifth dynamic register (D5) at the output of the fourth pipeline stage (P4) and input of the fifth pipeline stage (P5), in that the central clock supply is connected by a second to fifth clock output (PMQ, PM, PSQ, PS) to the first, second, fourth and fifth registers (D1, D2, D3, D4, D5) and the first clock output (PI, PI′) and second clock output (PIQ, PIQ′) of the input-clock generator (ET) are wired to the static registers (SR) and the static registers with reset circuit (SRR), while the first clock output (PO, PO′) and second clock output (POQ, POQ′) are connected to the fourth dynamic registers (D4).

12. A memory hierarchically constructed from memory cells according to one of the preceding claims, characterized in that a transfer gate is constructed from a field-effect transistor of the first conduction type and a field-effect transistor of the second conduction type, in that the field-effect transistor of the first conduction type is wired in parallel with the field-effect transistor of the second conduction type, and a gate connection of the field-effect transistor of the second conduction type forms the second control input and a gate connection of the field-effect transistor of the first conduction type forms the first control input of a transfer gate.

13. A memory hierarchically constructed from memory cells according to Claim 12, characterized in that a field-effect transistor of the first conduction type is an n-channel field-effect transistor and a field-effect transistor of a second conduction type is a p-channel field-effect transistor.

## Revendications

1. Mémoire à structure hiérarchique, qui est constituée de cellules de mémoire et qui est subdivisée en des plans hiérarchiques inférieur, médian et supérieur, et dans laquelle un élément du premier plan hiérarchique (HO) est une cellule de mémoire, un élément du second plan hiérarchique (H1) est un groupe de cellules de mémoire et un élément de chaque plan hiérarchique immédiatement supérieur est constitué d'un groupe d'éléments du plan hiérarchique immédiatement inférieur, et à chaque plan hiérarchique sont associés un circuit de colonne et de ligne pour la commande, la lecture et l'enregistrement des éléments du plan hiérarchique, caractérisée par le fait que des éléments, qui requièrent une surface étendue, des circuits de colonnes et de lignes des plans hiérarchiques inférieurs sont réalisés dans des plans hiérarchiques supérieurs, que dans les plans hiérarchiques médian et supérieur, plusieurs étages pipeline (P1...P5) sont disposés entre les circuits de colonnes et de lignes de plans hiérachiques supérieur et inférieur voisins, les étages pipeline appartenant en partie au plan hiérarchique supérieur et en partie au plan hiérarchique inférieur, que la mémoire a une unité centrale d'alimentation en cadences servant à produire des cadences principales (PM, PMQ, PS, PSQ, PMB), qu'à chaque élément du plan hiérarchique inférieur est associé un générateur de cadences d'entrée/sortie (E/AT) servant à produire des cadences locales (PMBQ, PMBQQ, PI, PI′, PO, PO′), que les cadences principales sont envoyées aux étages pipeline du plan hiérarchique supérieur et aux générateurs de cadences d'entrée/sortie du plan hiérarchique inférieur et que les cadences locales sont envoyées aux étages pipeline du plan hiérarchique inférieur.

2. Cellule à structure hiérarchique constituée de cellules de mémoire suivant la revendication 1, caractérisée par le fait que les cellules de mémoire sont des cellules de mémoire statiques et que chaque cellule de mémoire est équipée d'une ligne de transmission de données pour l'introduction d'informations dans la cellule de mémoire, et d'une ligne de transmission de données pour la lecture d'informations à partir de la cellule de mémoire.

3. Mémoire à structure hiérarchique constituée de cellules de mémoire suivant la revendication 1 ou 2, caractérisée par le fait que des circuits de décodage pour des conducteurs de transmission d'adresses de colonnes et de transmission d'adresses de lignes dans le circuit de colonnes et de lignes du plan hiérarchique inférieur (H1) sont réalisés dans un plan hiérarchique supérieur (H3).

4. Mémoire à structure hiérarchique constituée de cellules de mémoire suivant l'une des revendications 1 à 3, caractérisée par le fait que l'étage hiérarchique supérieur (H3) comprend cinq étages pipeline (P1...P5) disposés séquentiellement les uns à la suite des autres, que des premiers registres dynamiques (D1) sont raccordés à des entrées du premier étage pipeline (P1), que des seconds registres dynamiques (D2) sont branchés entre des sorties du premier étage pipeline (P1) et des entrées du second étage pipeline (P2), que des quatrièmes registres dynamiques (D4) sont branchés entre des sorties du troisième étage pipeline (P3) et des entrées du quatrième étage pipeline (P4) et que des cinquièmes registres dynamiques (D5) sont disposés entre des sorties du quatrième étage pipeline (P4) et des entrées du cinquième étage pipeline (P5), que des registres statiques (SR) et des registres statiques comportant des circuits de remise à l'état initial (SRR) sont prévus entre des sorties du second étage pipeline (P2) et des entrées du troisième étage pipeline (P3), que le premier étage pipeline contient des circuits de décodage (DK1...DK3) pour le décodage des conducteurs de transmission d'adresses de lignes et de transmission d'adresses de colonnes et des circuits amplificateurs (V1) pour les conducteurs (R/W′, DIN) d'enregistrement, de lecture et d'entrée de données, que le second étage pipeline (P2) contient des circuits amplificateurs (V2) pour les conducteurs (Z1,Z2,S1,S2) de transmission d'adresses de lignes et de colonnes et pour les conducteurs (R/W′, DIN) d'enregistrement, de lecture et d'entrée de données, que le troisième étage pipeline (P3) contient des éléments du plan hiérarchique immédiatement inférieur (H2) et un générateur de cadences d'entrée/sortie (E/AT) associé à chaque élément, les bits d'adresses décodés de poids fort (A10...A13) étant reliés, en tant que signaux de sélection de blocs (BS2), aux générateurs de cadence d'entrée/sortie (E/AT), que les troisième et quatrième étages pipeline (P3, P4) contiennent plusieurs portes NON-OU (NOR1...NOR3) et que le cinquième étage pipeline contient une porte NON-ET (NAND1), ces portes étant utilisées respectivement pour réunir des conducteurs de sortie de données (DOUT) des éléments du plan hiérarchique immédiatement inférieur (H2), et que le registre dynamique (D1,D2,D4,D5) est relié, pour la commande, à des seconde, troisième, quatrième et cinquième sorties de cadence (PM, PMQ, PS, PSQ) de l'unité centrale d'alimentation en cadences.

5. Mémoire à structure hiérarchique constituée de cellules de mémoire suivant l'une des revendications 1 à 4, caractérisée par le fait que l'unité centrale d'alimentation en cadences contient une entrée de cadence (P) et cinq sorties de cadences (PMB, PM, PMQ, PS, PSQ), une seconde porte NON-ET (NAND2), une quatrième porte NON-OU (NOR4), des troisième et quatrième portes de transfert (TG3, TG4) et 28 inverseurs, que l'entrée de cadence (P) est reliée à une première entrée de la seconde porte NON-ET (NAND2) et à une première entrée de la quatrième porte NON-OU (NOR4), qu'une sortie de la seconde porte NON-ET (NAND2) est reliée par l'intermédiaire d'un douzième inverseur (I12) à une seconde entrée de la quatrième porte NON-OU (NOR4), une sortie de la quatrième porte NON-OU (NOR4) est reliée par l'intermédiaire d'un onzième inverseur (I11) à la seconde entrée de la seconde porte NON-ET (NAND2), que la sortie de la seconde porte NON-ET (NAND2) est reliée par trois inverseurs branchés séquentiellement les uns derrière les autres, à la première sortie de cadence de l'unité centrale d'alimentation en cadences (PMB), que la sortie de la seconde porte NON-ET (NAND2) est reliée par l'intermédiaire de la troisième porte de transfert (TR3) et par l'intermédiaire d'un premier groupe, qui y est raccordé, de six inverseurs branchés séquentiellement les uns derrière les autres, à la seconde sortie de cadence (PMQ) de l'unité centrale d'alimentation en cadences, qu'entre la sortie du douzième inverseur (I12) et la troisième sortie de cadence (PM) de l'unité centrale d'alimentation en cadence est disposé un second groupe de six inverseurs branchés séquentiellement les uns derrière les autres, qu'un troisième groupe de six inverseurs branchés séquentiellement les uns derrière les autres est branché entre la quatrième sortie de cadence (PS4) et une sortie du onzième inverseur (I11), et que la sortie de la quatrième porte NON-OU (NOR4) est reliée, par l'intermédiaire d'une quatrième porte de transfert (TG4), reliée à un quatrième groupe, de six inverseurs branchés séquentiellement les uns derrière les autres, à la cinquième sortie de cadence (PS) de l'unité centrale d'alimentation en cadences.

6. Mémoire à structure hiérarchique constituée de cellules de mémoire suivant la revendication 4 ou 5, caractérisée par le fait que chaque générateur de cadence d'entrée/sortie (E/AT) contient un générateur de cadences d'entrée et un générateur de cadences de sortie (ET, AT), des troisième, quatrième et cinquième inverseurs (I3, I4, I5), un troisième registre dynamique (D3) et une porte de transfert (TG1), et en outre une entrée de commande de cadence, une entrée de sélection de blocs ainsi que quatre sorties de cadences, que l'entrée de sélection de blocs est reliée à la première entrée du générateur de cadences d'entrée (ET) et, par l'intermédiaire du troisième inverseur (I3), de la première porte de transfert (TG1) et du troisième registre dynamique (D3), à une première entrée du générateur de cadence de sortie (AT), que l'entrée de commande de cadence est raccordée à une seconde entrée du générateur de cadences d'entrée (ET) et, par l'intermédiaire, d'un quatrième inverseur (I4), à une seconde entrée du générateur de sortie (AT), que la sortie du quatrième inverseur (I4) est en outre reliée à une première borne de commande du troisième registre dynamique (D3) et, par l'intermédiaire d'un cinquième inverseur (I5), à une seconde borne de commande du troisième registre dynamique (D3), en commun avec une borne de commande de la première porte de transfert (TG1), et que le générateur de cadence d'entrée/sortie (E/AT) a des première et seconde sorties de cadences (P1,PTQ;PO,POQ).

7. Mémoire à structure hiérarchique constituée de cellules de mémoire suivant la revendication 6, caractérisée par le fait que le générateur de cadence d'entrée (ET) comporte une troisième porte NON-ET (NAND3), cinq inverseurs et une cinquième porte de transfert (TG5), le générateur de cadence de sortie (AT) contient une quatrième porte NON-OU (NAND4), cinq autres inverseurs et une sixième porte de transfert (TG6), que la première entrée du générateur de cadence d'entrée (ET) est reliée à une première entrée de la troisième porte NON-ET (NAND3), que la seconde entrée du générateur de cadences d'entrée (ET) est reliée à une seconde entrée de la troisième porte NON-ET (NAND3), qu'une sortie de la troisième porte NON-OU (NAND3) forme, par l'intermédiaire d'un premier groupe de trois inverseurs branchés les uns derrière les autres, la première sortie de cadence (PI,PIQ′) du générateur de cadences d'entrée (ET) et forme, par l'intermédiaire d'une cinquième porte de transfert (TG5), à laquelle est raccordé un premier groupe de deux inverseurs branchés l'un derrière l'autre, la seconde sortie de cadence (PIQ, PI′) du générateur de cadences d'entrée (ET), que la première entrée du générateur de sortie (AT) est réliée à une première entrée de la quatrième porte NON-ET (NAND4) et que la seconde entrée du générateur de cadence de sortie (AT) est reliée à une seconde entrée de la quatrième porte NON-ET (NAND4), qu'une sortie de la quatrième porte NON-ET (NAND4) représente, par l'intermédiaire de la sixième porte de transfert (TG6) et du second groupe, qui y est raccordé, de deux inverseurs branchés l'un derrière l'autre, la première sortie de cadence (PO, POQ′) du générateur de cadences de sortie (AT) et, par l'intermédiaire d'un second groupe de trois inverseurs branchés les uns derrière les autres, la seconde sortie de cadence (POQ, PO′) du générateur de cadences (AT).

8. Mémoire à structure hiérarchique constituée de cellules de mémoire suivant l'une des revendications précédentes, caractérisée par le fait qu'un registre dynamique contient deux portes de transfert et deux inverseurs branchés l'un derrière l'autre et que les deux inverseurs branchés l'un derrière l'autre sont disposés entre les première et seconde portes de transfert.

9. Mémoire à structure hiérarchique constituée de cellules de mémoire suivant l'une des revendications précédentes, caractérisée par le fait qu'un registre hiérarchique contient deux portes de transfert et des premier, second et troisième inverseurs, que les premier et second inverseurs sont branchés en série entre les première et seconde portes de transfert, le premier inverseur et la première porte de transfert étant disposés dans la zone d'entrée, et la seconde porte de transfert et le second inverseur étant disposés dans la zone de sortie du registre statique, et que le troisième inverseur représente une liaison de rétroaction entre une sortie du premier inverseur et une entrée du premier inverseur.

10. Mémoire à structure hiérarchique constituée de cellules de mémoire suivant l'une des revendications précédentes, caractérisée par le fait que dans un registre statique comportant un circuit de remise à l'état initial, le circuit de remise à l'état initial est disposé entre des septième et huitième portes de transfert (TG7, TG8), que le circuit de remise à l'état initial contient deux entrées de sélection de blocs, une cinquième porte NON-OU (NOR5), des treizième à dix-huitième inverseurs (I13...I19) et une cinquième porte NON-ET (NAND5), que la première entrée de sélection de blocs est raccordée à une première entrée de la cinquième porte NON-ET, la seconde entrée de sélection de bloc est reliée à une seconde entrée et, par l'intermédiaire des treizième, quatorzième et quinzième inverseurs branchés les uns derrière les autres (I13...I15), à une troisième entrée de la cinquième porte NON-OU (NOR5), une sortie de la cinquième porte NON-OU (NOR5) est reliée par l'intermédiaire d'un seizième inverseur (I16) à une première entrée de la cinquième porte NON-ET (NAND5), qu'une sortie de la septième porte de transfert (TG7) est raccordée à une seconde entrée de la cinquième porte NON-ET (NAND5), qu'une sortie de la cinquième porte NON-ET (NAND5) est couplée par rétroaction, par l'intermédiaire du dix-septième inverseur (I17), à la seconde entrée de la cinquième porte NON-ET et que la sortie de la cinquième porte NON-ET (NAND5) est reliée par l'intermédiaire du dix-huitième inverseur (I18) à la huitième porte de transfert (TG8) et au dix-neuvième inverseur (I19), qui lui est raccordé.

11. Mémoire à structure hiérarchique constituée de cellules de mémoire suivant l'une des revendications précédentes, caractérisée par le fait que la mémoire est une mémoire à 16K, qui est subdivisée, dans le plan hiérarchique supérieur (H3), en 16 x blocs 1K, un bloc 1K étant constitué de 16 blocs de chacun 64 bits et d'un générateur de cadence d'entrée/sortie (E/AT) , qu'à la mémoire sont associés des conducteurs de transmission d'adresses (A0-A13), un conducteur d'enregistrement et de lecture (R/W′), un conducteur d'entrée de données (DIN), un conducteur de sortie de données (DOUT), et une entrée de cadence (PMB), que les adresses supérieures (A0-A13) sont décodées par l'intermédiaire d'un décodeur d'adresses 4:16 (DK1) dans le premier étage pipeline (P1), sous la forme de signaux de sélection de blocs (BS2), qui sont appliqués, par l'intermédiaire de premiers inverseurs (I1), chacun à une entrée de sélection de bloc du générateur d'entrée/sortie associé (E/AT), que les adresses médianes (A6-A9) sont décodées par l'intermédiaire de deux décodeurs 2:4 (DK2) dans respectivement quatre conducteurs de transmission d'adresses de lignes et de transmission d'adresses de colonnes (Z2, S2), qui sont utilisés pour sélectionner des lignes et des colonnes de blocs de 64 bits, que les adresses inférieures (A0-A5) sont décodées par l'intermédiaire de deux décodeurs 3:8 (DK3), dans les huit conducteurs de transmission d'adresses de lignes et de colonnes (Z1, S1), qui sert à la sélection d'une ligne ou d'une colonne à l'intérieur des blocs à 64 bits, que les circuits amplificateurs (V2) pour les conducteurs décodés inférieurs et médians de transmission d'adresses de lignes et de colonnes dans le second étage pipeline (P2) et les circuits amplificateurs (V1,V2) pour le conducteur d'enregistrement/lecture (R/W′) et pour le conducteur d'entrée de données (DIN) dans les premier et second étages pipeline (P1, P2) sont constitués chacun de deux inverseurs branchés l'un derrière l'autre, que les quatre conducteurs (Z2) de transmission d'adresses de lignes pour la sélection d'une ligne de blocs de 64 bits sont reliés, par l'intermédiaire chacun d'un registre statique à circuits de remise à l'état initial (SRR) à chaque bloc 1K, et que les quatre conducteurs de colonnes (S2) pour la sélection d'une colonne de blocs à 64 bits, les huit conducteurs de transmission d'adresses de lignes et de transmission d'adresses de colonne (Z1,S1), qui sont utilisés pour sélectionner des lignes et des colonnes à l'intérieur des blocs à 64 bits, sont raccordés par l'intermédiaire chacun d'un registre statique (SR) à chaque bloc 1K, que le conducteur d'enregistrement/lecture (R/W′) est subdivisé, à l'entrée du troisième étage pipeline (P3), en un conducteur d'enregistrement et en un conducteur de lecture (R, W), le conducteur de lecture (R) étant relié, par l'intermédiaire d'un registre statique à un bloc 1K, tandis que le conducteur d'enregistrement (W) est relié par l'intermédiaire d'un registre statique associé à la sortie de la première porte de transfert, par l'intermédiaire d'un inverseur, en aval duquel est raccordée la porte de transfert, au bloc 1-K, que les quatre lignes des conducteurs de transmission de données des blocs à 64 bits sont réunis, par l'intermédiaire de premières portes NON-OU (NOR1), à 4 entrées et à une sortie, la première porte NON-OU (NOR1) étant disposée à l'intérieur du quatrième registre dynamique (D4), à la sortie du troisième étage pipeline (P3) et à l'entrée du quatrième étage pipeline (P4), qu'un élément résistif (W′) est relié, par une première borne, entre la sortie du troisième étage pipeline (P3) et l'entrée du quatrième étage pipeline (P4) et, par une seconde borne, à un potentiel de référence (VSS), que 8 des 16 conducteurs de transmission de données des 64 blocs de bits sont réunis par l'intermédiaire de seconde et troisième portes NON-OU (NOR2, NOR3) à 8 entrées et à une sortie, une porte NON-OU (NOR2, NOR3) ayant un inverseur (I7,I8), qui lui est raccordé, est disposée dans le quatrième étage pipeline (P4), et les sorties de ces deux portes NON-OU (NOR2, NOR3) sont en outre rassemblées en une première porte NON-ET (NAND1) comprenant deux entrées et une sortie, la première porte NON-ET (NAND1) étant disposée à l'intérieur du cinquième registre dynamique (D5) à la sortie du quatrième étage pipeline (P4) et à l'entrée du cinquième étage pipeline (P5), que l'unité centrale d'alimentation en cadence est reliée par des seconde à cinquième sorties de cadence (PMQ, PM, PSQ, PS) aux premier, second, quatrième et cinquième registres (D1,D2,D3,D4,D5), tandis que les première et seconde sorties de cadence (PI, PI′; PIQ, PIQ′) du générateur de cadence d'entrée (ET) sont reliés aux registres statiques (SR) et aux registres statiques comportant un circuit de remise à l'état initial (SRR), tandis que les première et seconde sorties de cadence (PO, PO′; POQ, POQ′) sont raccordées aux quatrièmes registres dynamiques (D4).

12. Mémoire à structure hiérarchique constituée de cellules de mémoire suivant l'une des revendications prédédentes, caractérisé par le fait qu'une porte de transfert est constituée d'un transistor à effet de champ d'un premier type de conduction et d'un transistor à effet de champ d'un second type de conduction, que le transistor à effet de champ ayant le premier type de conduction est branché en parallèle avec le transistor à effet de champ ayant le second type de conduction et qu'une borne de grille du transistor à effet de champ ayant le second type de conduction forme la seconde entrée de commande et qu'une borne de grille du transistor à effet de champ ayant le premier type de conduction forme la première entrée de commande d'une porte de transfert.

13. Mémoire à structure hiérarchique constituée de cellules de mémoire suivant la revendication 12, caractérisée par le fait qu'un transistor à effet de champ ayant un premier type de conduction est un transistor à effet de champ à canal n et qu'un transistor à effet de champ ayant le second type de conduction est un transistor à effet de champ à canal p.
